# EUROPEAN PATENT SPECIFICATION

(11) **EP 4 203 083 B1**
(45) Date of publication and mention of the grant of the patent: **11.11.2026**
(21) Application number: 22213579.0
(22) Date of filing: 14.12.2022
(51) Int. Cl.: H10K 59/131, H10H 29/49, H10K 59/82

(54) **DISPLAY DEVICE AND METHOD OF FABRICATING THE SAME**
ANZEIGEVORRICHTUNG UND VERFAHREN ZU IHRER HERSTELLUNG
DISPOSITIF D'AFFICHAGE ET SON PROCÉDÉ DE FABRICATION

(30) Priority: 27.12.2021 KR 20210188815
(43) Date of publication of application: 28.06.2023
(73) Proprietor: Samsung Display Co., Ltd., Yongin-si, Gyeonggi-do 17113 (KR)
(72) Inventor: YANG, Hui Won, 17113 Yongin-si (KR); SHIM, Dong Hwan, 17113 Yongin-si (KR); EO, Ji Hun, 17113 Yongin-si (KR); EOM, Tae Jong, 17113 Yongin-si (KR); LEE, Gwang Geun, 177113 Yongin-si (KR)
(74) Representative: Walaski, Jan Filip

(56) References cited:
- KR-A- 20150 134 953
- KR-A- 20160 038 959
- KR-A- 20210 063 010
- US-A1- 2014 375 916
- US-A1- 2015 021 081
- US-A1- 2019 267 440
- US-A1- 2020 051 966

## Description

### CROSS-REFERENCE TO RELATED APPLICATION

The present application claims priority to Korean patent application number 10-2021-0188815 filed on December 27, 2021.

### BACKGROUND

### 1. Field

Various embodiments of the present disclosure relate to a display device and a method of fabricating the display device.

### 2. Description of Related Art

With an increase in interest in an information display and an increase in demand to use portable information media, demand for display devices is markedly increased, and commercialization thereof is in progress.

KR2016 0038959, US2015/021081, KR 20210063010 and US2014/375916 disclose display devices having a substrate and a plurality of layers between the substrate and a pad layer.

### SUMMARY

Various embodiments of the present disclosure are directed to a display device capable of preventing defects from occurring on a rear line or the like disposed on the base layer, and a method of fabricating the display device.

A display device is provided in accordance with claim 1.

A method of fabricating a display device is provided in accordance with claim 9.

**- [0024]**

### BRIEF DESCRIPTION OF THE DRAWINGS

FIG. 1 is a schematic plan view illustrating a display device in accordance with an embodiment.
FIG. 2 is a schematic plan view illustrating a display panel in accordance with an embodiment.
FIG. 3 is a plan view schematically illustrating arrangement of pixels and pixel circuits in the display panel in accordance with an embodiment.
FIG. 4 is a plan view illustrating a display device including the display panel of FIG. 3.
FIG. 5 is a sectional view schematically illustrating a display device in accordance with an embodiment.
FIG. 6 is a view illustrating one surface of a base layer in the display device in accordance with an embodiment.
FIG. 7 is a sectional view taken along line VI-VI' of FIG. 6.
FIGS. 8, 9, 10 and 11 are sectional views sequentially illustrating a method of fabricating the display device of FIG. 7.
FIG. 12 is a perspective view illustrating a light emitting element included in the display device in accordance with an embodiment.
FIG. 13 is a sectional view illustrating the light emitting element included in the display device in accordance with an embodiment.
FIG. 14 is a sectional view schematically illustrating a pixel of the display device including the light emitting element of FIGS. 12 and 13.
FIG. 15 is a sectional view illustrating another example of a light emitting element included in the display device in accordance with an embodiment.
FIG. 16 is a sectional view schematically illustrating a pixel of the display device in accordance with an embodiment.
FIG. 17 is a sectional view schematically illustrating a portion of a non-display area of the display device in accordance with an embodiment.
FIG. 18 is a sectional view schematically illustrating a display area and the non-display area of the display device in accordance with an embodiment.
FIG. 19 is a sectional view of the display device in accordance with an embodiment.
FIG. 20 is a block diagram schematically illustrating a configuration of the display device in accordance with an embodiment.
FIG. 21 is a diagram schematically illustrating a pixel circuit of the display device in accordance with an embodiment.
FIG. 22 is a circuit diagram illustrating a pixel circuit of the display device in accordance with an embodiment.

### DETAILED DESCRIPTION

As the present disclosure allows for various changes and numerous embodiments, particular embodiments will be illustrated in the drawings and described in detail in the written description.

It will be understood that, although the terms "first", "second", etc. may be used herein to describe various elements, these elements should not be limited by these terms. These terms are only used to distinguish one element from another element. For instance, a first element discussed below could be termed a second element without departing from the teachings of the present disclosure. Similarly, the second element could also be termed the first element. In the present disclosure, the singular forms are intended to include the plural forms as well, unless the context clearly indicates otherwise.

It will be further understood that the terms "comprise", "include", "have", etc. when used in this specification, specify the presence of stated features, integers, steps, operations, elements, components, and/or combinations of them but do not preclude the presence or addition of one or more other features, integers, steps, operations, elements, components, and/or combinations thereof. Furthermore, in case that a first part such as a layer, a film, a region, or a plate is disposed on a second part, the first part may be not only directly on the second part but a third part may intervene between them. In addition, when it is expressed that a first part such as a layer, a film, a region, or a plate is formed on a second part, the surface of the second part on which the first part is formed is not limited to an upper surface of the second part but may include other surfaces such as a side surface or a lower surface of the second part. To the contrary, in case that a first part such as a layer, a film, a region, or a plate is under a second part, the first part may be not only directly under the second part but a third part may intervene between them.

In this specification, the term "connection" between two components may embrace electrical connection and physical connection, but the present disclosure is not limited thereto.

Hereinafter, a display device in accordance with an embodiment of the present disclosure will be described with reference to the attached drawings.

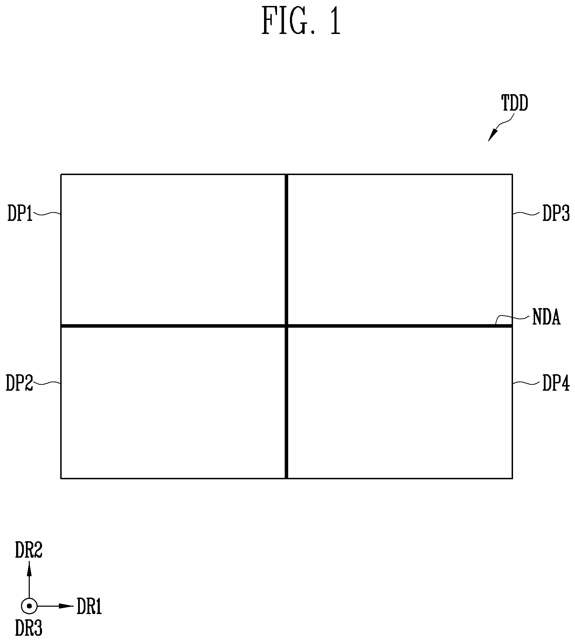

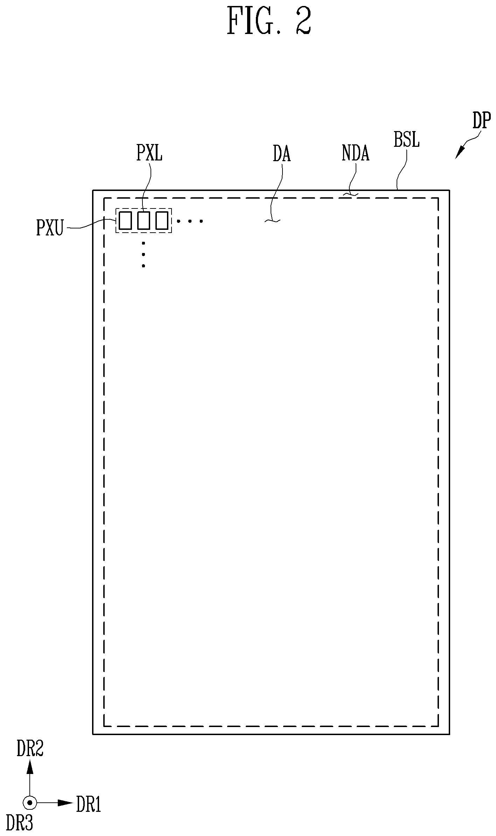

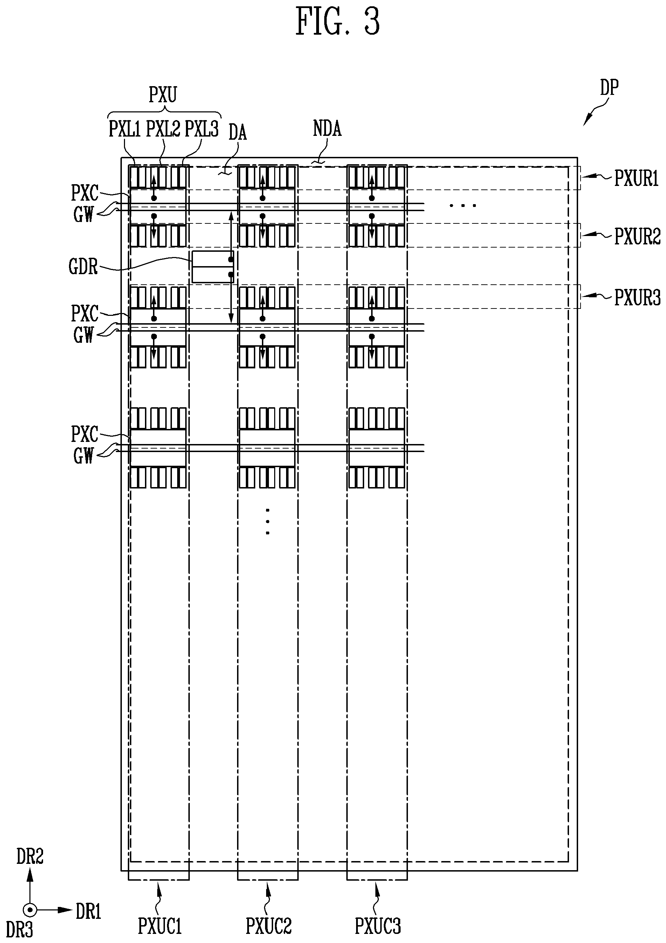

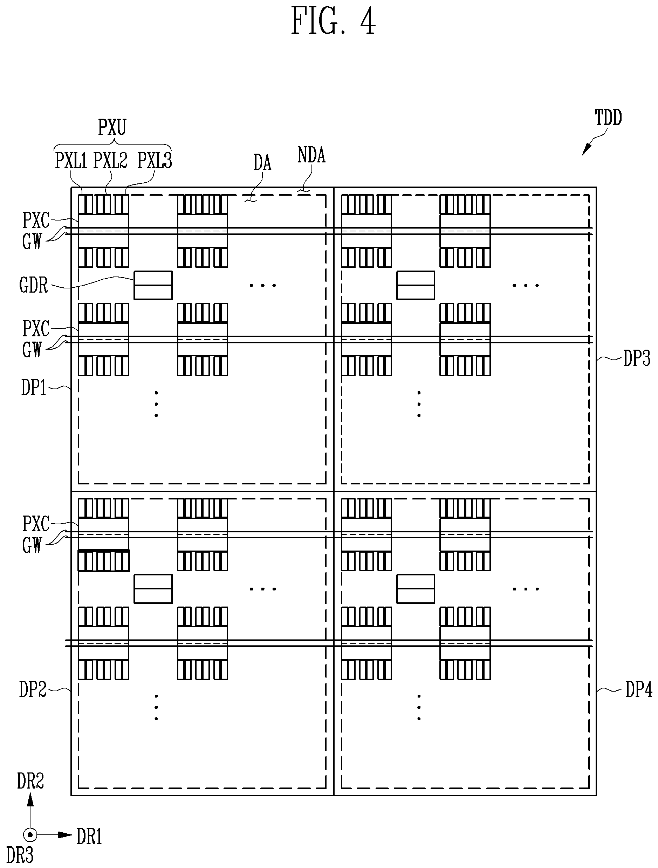

FIG. 1 is a schematic plan view illustrating a display device in accordance with an embodiment. FIG. 2 is a schematic plan view illustrating a display panel in accordance with an embodiment. FIG. 3 is a plan view schematically illustrating arrangement of pixels and pixel circuits in the display panel in accordance with an embodiment. FIG. 4 is a plan view illustrating a display device including the display panel of FIG. 3. A plurality of display devices in accordance with an embodiment may form a multiscreen display device TDD (referred also to as a tiled display) including a plurality of display panel.

Referring to FIGS. 1 and 2, the multiscreen display device TDD in accordance with an embodiment may include a plurality of display panels DP1, DP2, DP3, and DP4 arranged in a matrix configuration in a first direction DR1 and a second direction DR2.

The plurality of display panels DP1, DP2, DP3, and DP4 may respectively display individual images or partitively display one image. The plurality of display panels DP1, DP2, DP3, and DP4 may include display panels having the same type, structure, size, or scheme, but the present disclosure is not limited thereto.

The plurality of display panels DP1, DP2, DP3, and DP4 may be physically coupled, so as to form the single multiscreen display device TDD, to a housing (not illustrated) that may be disposed under the plurality of display panels DP1, DP2, DP3, and DP4.

The plurality of display panels DP1, DP2, DP3, and DP4 each may be embodied in various shapes. Although FIG. 1 illustrates that the plurality of display panels DP1, DP2, DP3, and DP4 each has a rectangular plate shape, the present disclosure is not limited thereto. For example, the plurality of display panels DP1, DP2, DP3, and DP4 each may have a circular or elliptical shape.

The display panel DP in accordance with an embodiment may include a display area DA in which an image is displayed, and a non-display area NDA in which no image is displayed. The non-display area NDA may be a bezel area which encloses the display area DA.

The display area DA may be disposed on one surface of the display panel DP. For example, the display area DA may be disposed not only on a front surface of the display panel DP but also additionally disposed on a side surface or a rear surface of the display panel DP.

The display area DA may include a plurality of pixels PXL. A plurality of pixels PXL may form each pixel unit PXU. Although FIG. 2 illustrates one pixel unit PXU including three pixels PXL, a plurality of pixel units PXU may be dispersed and disposed on an overall surface of the display area DA. For example, the pixels PXL may be disposed in the display area DA in a matrix or stripe arrangement manner. However, the present disclosure is not limited thereto.

The non-display area NDA may be disposed around the display area DA to enclose the display area DA. The non-display area NDA may selectively include lines, pads, a driving circuit, and the like which are connected to the pixels PXL of the display area DA.

In the plurality of display panels DP1, DP2, DP3, and DP4, an image displayed on a screen of the multiscreen display device TDD may be divided into parts by the non-display area NDA that is disposed in a boundary area between the plurality of display panels DP1, DP2, DP3, and DP4. However, in the display device in accordance with an embodiment, the non-display area NDA may be minimized so that, when a user views the image, the non-display area NDA cannot be visible. For example, a gap (e.g., a gap with respect to the first direction DR1 and/or a gap with respect to the second direction DR2) of the non-display area NDA between two adjacent display panels of the plurality of display panels DP1, DP2, DP3, and DP4 may correspond to a distance (or a gap) between outermost pixel units included in each of the two adjacent display panels. Here, in accordance with an embodiment of the present disclosure, the distance (or the gap) between the outermost pixel units included in each of the two adjacent display panels may be substantially the same as a distance (or a gap) between the pixel units included in each display panel. In this case, even if the multiscreen display device TDD includes the plurality of display panels DP1, DP2, DP3, and DP4, the boundary area (i.e., the non-display area NDA) between the plurality of display panels DP1, DP2, DP3, and DP4 may not be visible to the user. The non-display area NDA disposed in the boundary area between the plurality of display panels DP1, DP2, DP3, and DP4 may be referred to as a seam area, an assembly joint area, or a dead space area.

Referring to FIGS. 3 and 4, the display area DA of each display panel DP in accordance with an embodiment may include a plurality of pixel units PXU, a plurality of pixel circuits PXC, at least one gate driving circuit GDR, and a gate line GW. A display device illustrated in FIG. 4 may correspond to a multiscreen display device TDD in which the display panels DP of FIG. 3 are arranged in the matrix configuration in the first direction DR1 and the second direction DR2.

The plurality of pixel units PXU may be spaced apart from each other and disposed in a matrix configuration along the first direction DR1 and the second direction DR2. The plurality of pixel units PXU each may include a first pixel PXL1, a second pixel PXL2, and/or a third pixel PXL3. The first pixel PXL1, the second pixel PXL2, and the third pixel PXL3 may be disposed at positions spaced apart from each other in the first direction DR1. The first pixel PXL1, the second pixel PXL2, and the third pixel PXL3 each may include a plurality of sub-pixels. For example, the first pixel PXL1, the second pixel PXL2, and the third pixel PXL3 each may be formed of two sub-pixels. In an embodiment, the first pixel PXL1 may be a red pixel, the second pixel PXL2 may be a green pixel, and the third pixel PXL3 may be a blue pixel. The present disclosure is not limited to the foregoing embodiments, and the first to third pixels PXL1, PXL2, and PXL3 may be pixels configured to emit different colors of light.

The pixel circuit PXC may be disposed between two pixel units PXU of the plurality of pixel units PXU that are disposed adjacent to each other in the second direction DR2. For example, in case that pixel units PXU that are disposed on a first row in the first direction DR1 are referred to as first row pixel units PXUR1, and pixel units PXU that are disposed on a second row are referred to as second row pixel units PXUR2, at least one pixel circuit PXC may be disposed between the first row pixel units PXUR1 and the second row pixel units PXUR2. The pixel circuit PXC may include circuit elements and drive two pixel units PXU that are adjacent thereto in the second direction DR2. For example, the pixel circuit PXC may drive the first row pixel unit PXUR1 and the second row pixel unit PXUR2.

The gate driving circuit GDR may be disposed between two pixel units PXU spaced apart from each other by a distance in the second direction DR2 and between two pixel units PXU spaced apart from each other by a distance in the first direction DR1. For example, in case that pixel units PXU that are disposed on a third row spaced apart from the second row pixel unit PXUR2 by a distance are referred to as third row pixel units PXUR3, pixel units PXU that are disposed on a first column in the second direction DR2 are referred to as first column pixel units PXUC1, and pixel units PXU that are disposed on a second column are referred to as second column pixel units PXUC2, the gate driving circuit GDR may be disposed between the second row pixel units PXUR2 and the third row pixel units PXUR3 and between the first column pixel units PXUC1 and the second column pixel units PXUC2.

The gate line GW may overlap the pixel circuits PXC and extend in the first direction DR1. The gate line GW may include two lines. Each of the lines may supply a gate signal to the pixel unit PXU disposed adjacent thereto. The gate line GW may supply, to the pixel units PXU, gate signals provided from the gate driving circuit GDR. For example, the gate line GW disposed between the first row pixel unit PXUR1 and the second row pixel unit PXUR2 may be supplied with gate signals from the gate driving circuit GDR. The gate line GW adjacent to the first row pixel unit PXUR1 may supply a gate signal to the first row pixel unit PXUR1. The gate line GW adjacent to the second row pixel unit PXUR2 may supply a gate signal to the second row pixel unit PXUR2.

As described with reference to FIGS. 1 and 2, the distance (or the gap) between the outermost pixel units PXU included in each of the two adjacent display panels of the plurality of display panels DP1, DP2, DP3, and DP4 may be substantially the same as the distance (or the gap) between the pixel units PXU included in each display panel. Therefore, even if the multiscreen display device TDD includes the plurality of display panels DP1, DP2, DP3, and DP4, the boundary area (i.e., the non-display area NDA) between the plurality of display panels DP1, DP2, DP3, and DP4 may not be visible to the user.

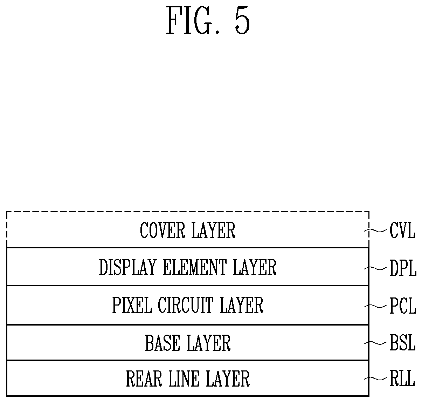

Hereinafter, the structure of the display device in accordance with an embodiment will be described with reference to FIG. 5.

FIG. 5 is a sectional view schematically illustrating the display device in accordance with an embodiment.

Referring to FIG. 5, the display device in accordance with an embodiment may include a pixel circuit layer PCL, a display element layer DPL, and a cover layer CVL that are successively disposed on a front surface of the base layer BSL, and a rear line layer RLL disposed on a rear surface of the base layer BSL.

The base layer BSL may form a base of the display device. In an embodiment, the base layer BSL may be a rigid or flexible substrate or film, and the material or properties thereof are not particularly limited. For example, the base layer BSL may be a rigid substrate made of glass or reinforced glass, a flexible substrate (or a thin film) formed of plastic or metal, or at least one insulating layer, and the material and/or properties thereof are not particularly limited.

The pixel circuit layer PCL may be disposed on the base layer BSL, and include a plurality of transistors and signal lines connected to the plurality of transistors. For example, each transistor may include a structure in which a semiconductor pattern, a gate electrode, a source electrode, and a drain electrode are successively stacked with insulating layers interposed therebetween.

The display element layer DPL may be disposed on the pixel circuit layer PCL and include light emitting elements. For example, the light emitting element may be an organic light emitting diode, an inorganic light emitting element, or a light emitting element which emits light after changing the wavelength of the light to be emitted using quantum dots.

The cover layer CVL may be disposed on the display element layer DPL. The cover layer CVL may be an encapsulation substrate or have the form of an encapsulation film having a multi-layer structure. In case that the cover layer CVL has the form of an encapsulation film, the cover layer CVL may have a structure formed by successively stacking an inorganic layer, an organic layer, and an inorganic layer. The cover layer CVL may include plastic such as polycarbonate, polypropylene, polyimide, and polyethylene terephthalate, and include material such as glass. The cover layer CVL may prevent external air or water from permeating into the display element layer DPL or the pixel circuit layer PCL.

In an embodiment, the cover layer CVL may be formed of a thermo-setting resin and/or a photo-setting resin, and may be applied in a liquid form to the base layer BSL, and then hardened through a curing process using heat and/or light. Here, the cover layer CVL may protect the light emitting element and also stably fix the light emitting element.

Furthermore, in an embodiment, a window may be provided on the cover layer CVL to protect the display device from an external impact and provide an input surface and/or a display surface to the user. In an embodiment, the cover layer CVL may be omitted.

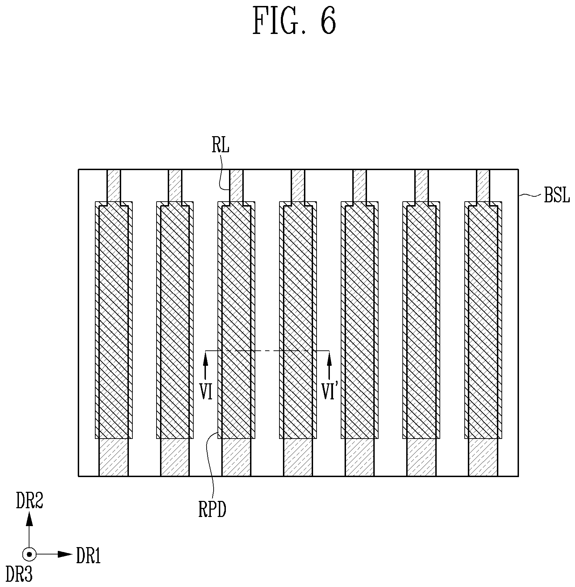

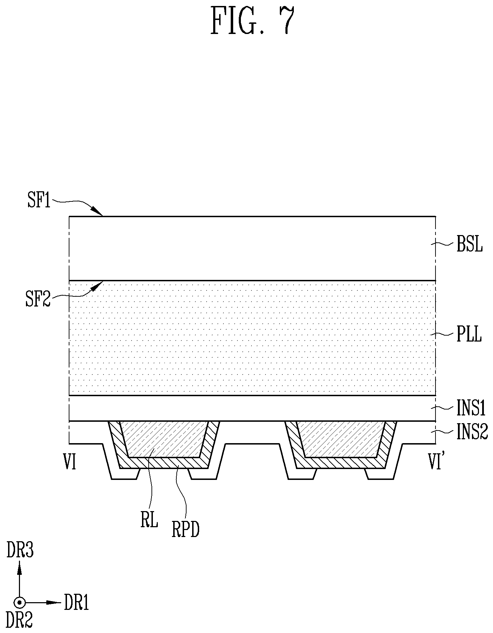

Hereinafter, the structure of a display device in accordance with an embodiment will be described with reference to FIGS. 6 and 7.

FIG. 6 is a view illustrating one surface of a base layer in the display device in accordance with an embodiment. FIG. 7 is a sectional view taken along line VI-VI' of FIG. 6.

Referring to FIG. 6, the display device in accordance with an embodiment of the invention includes a base layer BSL, a rear line RL, and a rear pad electrode RPD.

The rear line RL may be disposed on one surface of the base layer BSL. In an embodiment, the rear line RL may be disposed on the rear surface of the base layer BSL.

The rear line RL may extend in the second direction DR2. Furthermore, a plurality of rear lines RL may be spaced apart from each other with respect to the first direction DR1 and extend in the second direction DR2. For example, the rear line RL may be a rear data line configured to provide a data voltage to the pixel circuit layer PCL (refer to FIG. 5). The present disclosure is not limited to the foregoing embodiments. In embodiments, the rear line RL may correspond to at least one of signal lines that include a power line, a gate line, a sensing line, a control line, or the like. The rear line RL may be electrically connected to a circuit element such as a transistor of the pixel circuit layer PCL through a connection line or the like that may be disposed on a side surface of the base layer BSL.

The rear line RL may include metal material. For example, the rear line RL may have a single-layer structure formed of one or combination selected from the group consisting of copper (Cu), molybdenum (Mo), tungsten (W), aluminum neodymium (AlNd), titanium (Ti), aluminum (Al), silver (Ag), and an alloy thereof. Furthermore, the rear line RL may have a double-layer or multi-layer structure that further includes molybdenum (Mo), titanium (Ti), copper (Cu), aluminum (Al), or silver (Ag), which is low resistance material, so as to reduce line resistance.

The rear pad electrode RPD may partially extend in the second direction DR2, and at least partially overlap the rear line RL.

The rear pad electrode RPD may include transparent conductive oxide. For instance, the rear pad electrode RPD may include indium tin oxide (ITO), indium zinc oxide (IZO), zinc oxide (ZnO), indium gallium zinc oxide (IGZO), indium tin zinc oxide (ITZO), or the like.

Referring to FIG. 7, the display device in accordance with an embodiment may include a base layer BSL, a planarization layer PLL, a first insulating layer INS1, a rear line RL, a rear pad electrode RPD, and a second insulating layer INS2 disposed on the rear surface of the base layer BSL.

The base layer BSL may include a first surface SF1, and a second surface SF2 that is a surface opposite to the first surface SF1. In an embodiment, the first surface SF1 may be referred to as a front surface, and the second surface SF2 may be referred to as a rear surface. The present disclosure is not limited the foregoing embodiments. In embodiments, the first surface SF1 may be referred to as a rear surface, and the second surface SF2 may be referred to as a front surface.

The pixel circuit layer PCL (refer to FIG. 5), the display element layer DPL (refer to FIG. 5), and the like may be disposed on the first surface SF1 of the base layer BSL.

The planarization layer PLL may be disposed on the second surface SF2 of the base layer BSL. The planarization layer PLL may cover an overall surface of the second surface SF2 of the base layer BSL and planarize the second surface SF2 of the base layer BSL. Hence, the planarization layer PLL may enable a line, an electrode, and the like to be stably disposed on the second surface SF2 of the base layer BSL. In other words, even if the second surface SF2 of the base layer BSL is uneven due to an impurity that is present on the second surface SF2 of the base layer BSL or a scratch, a crack, or the like formed in the base layer BSL, the planarization layer PLL may planarize the second surface SF2 of the base layer BSL, thus securing the structural stability of the display device.

The planarization layer PLL may be formed of an organic insulating layer including organic material (or substance). The planarization layer PLL may include, for example, polyacrylates resin, epoxy resin, phenolic resin, polyamides resin, polyimides resin, unsaturated polyesters resin, poly-phenylen ethers resin, poly-phenylene sulfides resin, benzocyclobutene resin, or the like.

The first insulating layer INS1 may be disposed on the planarization layer PLL. The first insulating layer INS1 may cover the entirety of one surface of the planarization layer PLL.

The first insulating layer INS1 may be formed of an inorganic insulating layer including inorganic material (or substance). Furthermore, the first insulating layer INS1 may include transparent inorganic insulating material.

The rear line RL is disposed on the first insulating layer INS1. Since the second surface SF2 of the base layer BSL is planarized by the planarization layer PLL and the first insulating layer INS1, the rear line RL may be stably disposed on the first insulating layer INS1 without a defect such as a short circuit or a step difference.

The rear pad electrode RPD is disposed on the rear line RL. The rear pad electrode RPD is disposed on the rear line RL and the first insulating layer INS1 so that the rear line RL is covered with the rear pad electrode RPD.

The second insulating layer INS2 may be disposed on the rear pad electrode RPD. The second insulating layer INS2 may cover the rear pad electrode RPD such that at least a portion of an upper surface of the rear pad electrode RPD is exposed, and may cover the first insulating layer INS1. A circuit substrate or the like may be attached to the upper surface of the rear pad electrode RPD that is exposed from the second insulating layer INS2.

The second insulating layer INS2 may be formed of an inorganic insulating layer including inorganic material. For example, the second insulating layer INS2 may include at least one of silicon nitride (SiNₓ), silicon oxide (SiOₓ), silicon oxynitride (SiOₓN_{y}), and metal oxide such as aluminum oxide (AlOₓ). In embodiment, a rear via layer (not illustrated) may be disposed between the first insulating layer INS1 and the second insulating layer INS2.

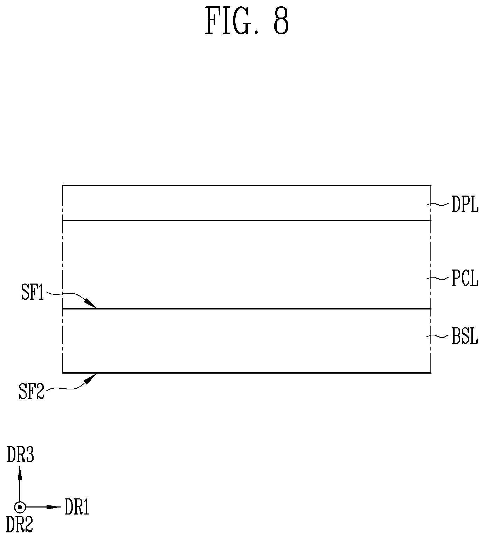

Hereinafter, a method of fabricating the display device in accordance with an embodiment will be described with reference to FIGS. 8 to 11.

FIGS. 8 to 11 are sectional views sequentially illustrating a method of fabricating the display device of FIG. 7.

Referring to FIG. 8, the base layer BSL is prepared, and the pixel circuit layer PCL and the display element layer DPL may be sequentially formed on the first surface SF1 of the base layer BSL. For example, the base layer BSL may be formed of a rigid substrate such as a glass substrate, a quartz substrate, a glass ceramic substrate, or a crystalline glass substrate. Alternatively, the base layer BSL may be formed of a flexible substrate including flexible material. For instance, examples of the material having flexibility may include at least one of the following: polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and cellulose acetate propionate. However, the material constituting the base layer BSL is not limited to that of the foregoing embodiments. For example, in the pixel circuit layer PCL, a first transistor may be formed on the first surface SF1. In the display element layer DPL, a light emitting element may be disposed on the pixel circuit layer PCL.

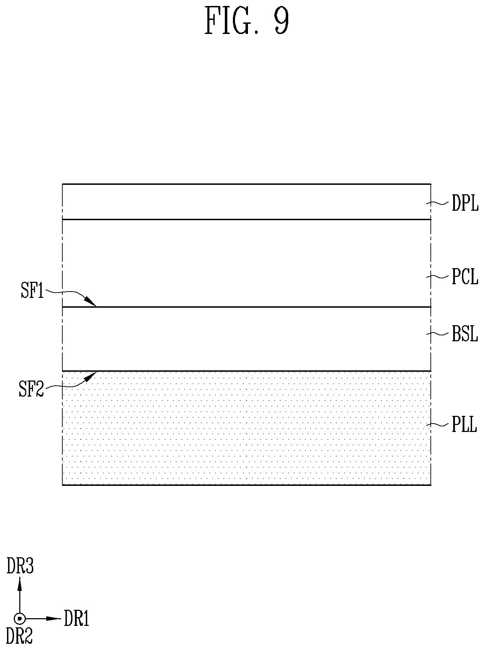

Referring to FIG. 9, the planarization layer PLL is formed on the second surface SF2 of the base layer BSL. For example, the planarization layer PLL may be formed of an organic insulating layer including polyacrylates resin, epoxy resin, phenolic resin, polyamides resin, polyimides resin, unsaturated polyesters resin, poly-phenylen ethers resin, poly-phenylene sulfides resin, benzocyclobutene resin, or the like.

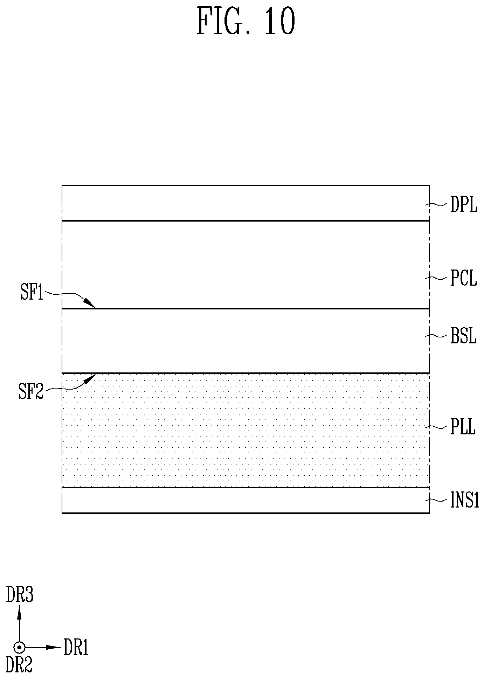

Referring to FIG. 10, the first insulating layer INS1 is formed on the planarization layer PLL. For example, the first insulating layer INS1 may be formed of a transparent inorganic insulating layer.

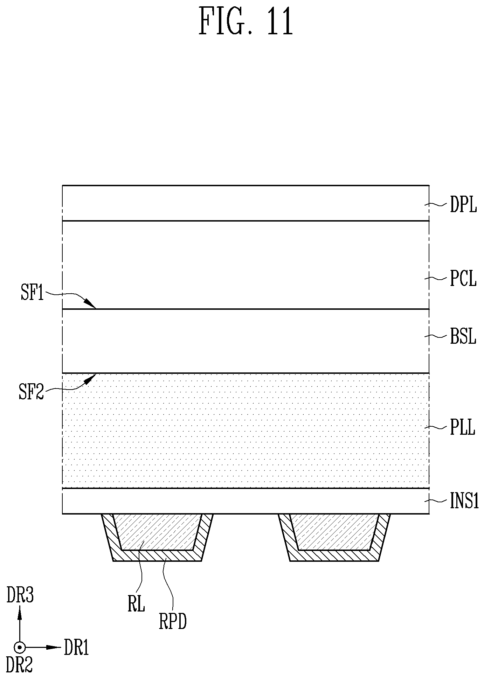

Referring to FIG. 11, the rear line RL and the rear pad electrode RPD are formed on the first insulating layer INS1. In detail, two rear lines RL may be formed at positions spaced apart from each other with respect to the first direction DR1. Two rear pad electrodes RPD may be spaced apart from each other in the first direction DR1 and formed to cover the two rear lines RL. For example, the rear line RL may have a single-layer structure formed of one or combination selected from the group consisting of copper (Cu), molybdenum (Mo), tungsten (W), aluminum neodymium (AlNd), titanium (Ti), aluminum (Al), silver (Ag), and an alloy thereof, or may be implemented as a double-layer or multi-layer structure that further includes molybdenum (Mo), titanium (Ti), copper (Cu), aluminum (Al), or silver (Ag), which is low resistance material, so as to reduce line resistance. The rear pad electrode RPD may include transparent conductive material that includes conductive oxide such as indium tin oxide (ITO), indium zinc oxide (IZO), zinc oxide (ZnO), indium gallium zinc oxide (IGZO), and indium tin zinc oxide (ITZO), a conductive polymer such as PEDOT (poly(3,4-ethylenedioxythiophene)), etc.

Referring again to FIG. 7, the second insulating layer INS2 may be formed on the rear pad electrode RPD and the first insulating layer INS1 to cover the rear pad electrode RPD and the first insulating layer INS1. For example, the second insulating layer INS2 may be formed of an inorganic insulating layer including silicon nitride (SiNₓ), silicon oxide (SiOₓ), silicon oxynitride (SiOₓN_{y}), aluminum oxide (AlOₓ), or the like.

In the display device in accordance with an embodiment, after the pixel circuit layer PCL, the display element layer DPL, and the like are formed on the first surface SF1 of the base layer BSL, the rear line RL, the rear pad electrode RPD, and the like may be formed on the second surface SF2 of the base layer BSL.

As the pixel circuit layer PCL, the display element layer DPL, and the like are formed on the first surface SF1 of the base layer BSL, a foreign substance may be present on the second surface SF2 of the base layer BSL, and a scratch, a crack, or the like may be formed in the second surface SF2 of the base layer BSL. In an embodiment, the planarization layer PLL may be formed on the second surface SF2 of the base layer BSL, and then the rear line RL, the rear pad electrode RPD, and the like may be formed. Hence, a defect may be prevented from occurring on the rear line RL or the like, and the structural stability of the display device may be secured.

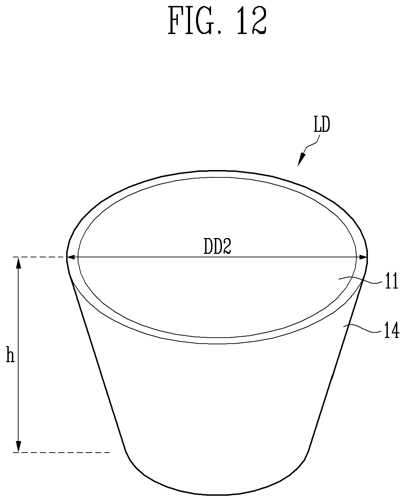

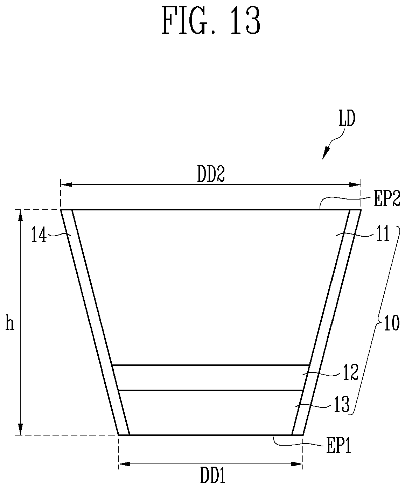

Hereinafter, a light emitting element included in a pixel of the display device in accordance with an embodiment will be described with reference to FIGS. 12 and 13.

FIG. 12 is a perspective view illustrating a light emitting element included in the display device in accordance with an embodiment. FIG. 13 is a sectional view illustrating the light emitting element included in the display device in accordance with an embodiment.

Referring to FIGS. 12 and 13, the light emitting element LD may include a first semiconductor layer 11, an active layer 12, and a second semiconductor layer 13. For example, the light emitting element LD may include an emission stack 10 formed by successively stacking the first semiconductor layer 11, the active layer 12, and the second semiconductor layer 13. In an embodiment, the light emitting element LD may further include a coupling electrode layer. The coupling electrode layer may be stacked on one surface of the first semiconductor layer 11 or one surface of the second semiconductor layer 13.

A lower surface of the light emitting element LD with respect to a height direction (h) may be referred to as a first end EP1 and an upper surface thereof may be referred to as a second end EP2.

The light emitting element LD may have a column shape in which a diameter DD1 of the first end EP1 and a diameter DD2 of the second end EP2 differ from each other. For example, the light emitting element LD may have a column shape in which the diameter DD1 of the first end EP1 is less than the diameter DD2 of the second end EP2. In detail, the light emitting element LD may have an elliptical column shape in which the diameter thereof is increased upward in the height direction (h). The present disclosure is not limited to the foregoing embodiments. In an embodiment, the light emitting element LD may have a column shape in which the diameter DD1 of the first end EP1 is greater than the diameter DD2 of the second end EP2. In other words, in an embodiment, the light emitting element LD may have an elliptical column shape in which the diameter thereof is reduced upward in the height direction (h).

In an embodiment, the light emitting element LD may be embodied such that the first end EP1 and the second EP2 each has a polygonal shape such as a rectangle, a square, a regular triangle, or a regular pentagon. In other words, in an embodiment, the light emitting element LD may have a truncated pyramid shape in which a surface area of the upper surface thereof differs from that of the lower surface thereof.

The light emitting element LD may have a size ranging from the nanometer scale to the micrometer scale. However, the size of the light emitting element LD is not limited thereto, and the size of the light emitting element LD may be changed in various ways depending on design conditions of various devices (e.g., a display device) using a light emitting device with the light emitting element LD as a light source.

The first semiconductor layer 11 may be formed of a first conductive type semiconductor layer. For example, the first semiconductor layer 11 may include at least one n-type semiconductor. For instance, the first semiconductor layer 11 may include an n-type semiconductor layer which includes any one semiconductor material of InAlGaN, GaN, AlGaN, InGaN, AlN, and InN and is doped with a first conductive dopant such as Si, Ge, or Sn. However, the constituent material of the first semiconductor layer 11 is not limited to thereto, and various other materials may be used to form the first semiconductor layer 11.

The active layer 12 may be disposed on one surface of the first semiconductor layer 11. The active layer 12 may be disposed on the first semiconductor layer 11. The active layer 12 may have a single or multiple quantum well structure. In an embodiment, a cladding layer (not illustrated) doped with a conductive dopant may be formed over and/or under the active layer 12. For example, the cladding layer may be formed of an AlGaN layer or an InAlGaN layer. In an embodiment, material such as AlGaN or InAlGaN may be used to form the active layer 12, and various other materials may be used to form the active layer 12.

If a voltage equal to or greater than a threshold voltage is applied between the upper surface and the lower surface of the light emitting element LD, the light emitting element LD may emit light due to a coupling of electron-hole pairs in the active layer 12. Since light emission of the light emitting element LD can be controlled based on the foregoing principle, the light emitting element LD may be used as a light source of various light emitting devices as well as a pixel of the display device.

The second semiconductor layer 13 may be disposed on one surface of the active layer 12. The second semiconductor layer 13 may be disposed over the active layer 12. The second semiconductor layer 13 may include a semiconductor layer having a conductivity type different from that of the first semiconductor layer 11. For example, the second semiconductor layer 13 may include at least one p-type semiconductor layer. For instance, the second semiconductor layer 13 may include a p-type semiconductor layer which includes any one semiconductor material of InAlGaN, GaN, AlGaN, InGaN, AlN, and InN, and is doped with a second conductive dopant such as Mg, Zn, Ca, Sr, or Ba. However, the material for forming the second semiconductor layer 13 is not limited thereto, and various other materials may be used to form the second semiconductor layer 13.

Although the first semiconductor layer 11 and the second semiconductor layer 13 each is formed of a single layer, the present disclosure is not limited thereto. In an embodiment, depending on the material of the active layer 12, the first semiconductor layer 11 and the second semiconductor layer 13 each may further include one or more layers, for example, a clad layer and/or a tensile strain barrier reducing (TSBR) layer. The TSBR layer may be a strain relief layer of which a lattice structure is disposed between other semiconductor layers so that the strain relief layer functions as a buffer layer to reduce a difference in lattice constant. Although the TSBR layer may be formed of a p-type semiconductor layer such as p-GaInP, p-AlInP, or p-AlGaInP, the present disclosure is not limited thereto.

In an embodiment, the light emitting element LD may further include an electrode disposed over the first semiconductor layer 11 and/or under the second semiconductor layer 13. Although the electrode may be an ohmic contact electrode, the present disclosure is not limited thereto. In an embodiment, the electrode may be a Schottky contact electrode. The electrode may include conductive material. For example, the electrode may include opaque metal such as chrome (Cr), titanium (Ti), aluminum (Al), gold (Au), nickel (Ni), and alloys thereof, or oxides of the opaque metal described above, which are used alone or in combination, but the present disclosure is not limited thereto. In an embodiment, the electrode may include transparent conductive oxide such as indium tin oxide (ITO), indium zinc oxide (IZO), zinc oxide (ZnO), indium gallium zinc oxide (IGZO), or indium tin zinc oxide (ITZO). Furthermore, the electrode may directly contacts the first semiconductor layer 11 (a cathode) and the second semiconductor layer 13 (an anode).

In an embodiment, the light emitting element LD may further include an insulating layer 14. In an embodiment, the insulating layer 14 may be omitted, or provided to cover only a portion of the emission stack 10.

The insulating layer 14 may prevent the active layer 12 from short-circuiting due to making contact with conductive material except the first and second semiconductor layers 11 and 13. Furthermore, the insulating layer 14 may minimize a surface defect of the light emitting element LD, thus enhancing the lifetime and emission efficiency of the light emitting element LD. In case that the light emitting elements LD are disposed in close contact with each other, the insulating layer 14 may prevent an undesired short-circuit from occurring between the light emitting elements LD. It is not limited whether the insulating layer 14 is provided, so long as the active layer 12 can be prevented from short-circuiting with external conductive material.

The light emitting element LD may further include a reflector that encloses an outer circumferential surface of the insulating layer 14. The reflector may be made of material having a reflectivity sufficient to enable light emitted from the light emitting element LD to travel in an image display direction and be focused on a specific area. For example, the reflector may be made of conductive material (or substance) having a certain reflectivity.

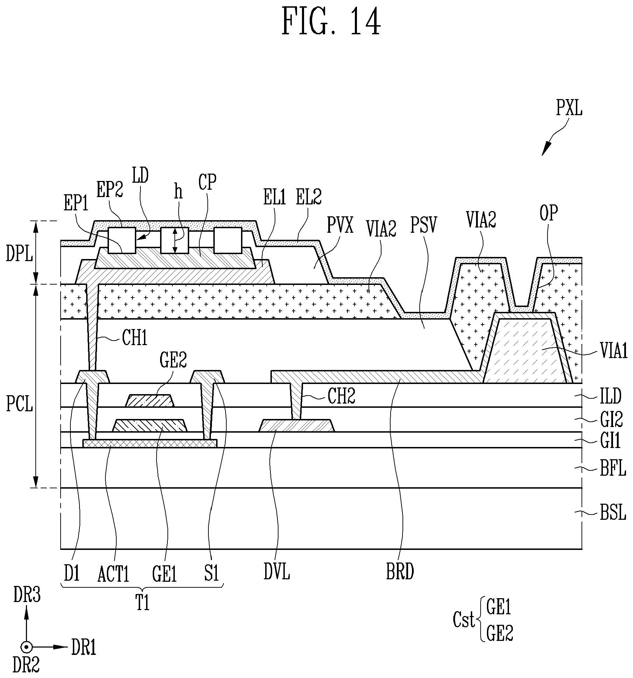

Hereinafter, the structure of the display device in accordance with an embodiment will be described with reference to FIG. 14.

FIG. 14 is a sectional view schematically illustrating a pixel of the display device including the light emitting element of FIGS. 12 and 13.

Referring to FIG. 14, the pixel PXL included in the display device in accordance with an embodiment may include a base layer BSL, a pixel circuit layer PCL, and a display element layer DPL. The base layer BSL, the pixel circuit layer PCL, and the display element layer DPL may respectively correspond to the base layer BSL, the pixel circuit layer PCL, and the display element layer DPL that are described with reference to FIGS. 5, and 8 to 11.

The base layer BSL may be formed of a rigid or flexible substrate. For example, in case that the base layer BSL is a rigid substrate, the base layer BSL may be formed of a glass substrate, a quartz substrate, a glass ceramic substrate, a crystalline glass substrate, or the like. In case that the base layer BSL is a flexible substrate, the base layer BSL may be formed of a polymer organic substrate including polyimide, polyamide, or the like, or a plastic substrate, or the like.

The pixel circuit layer PCL may be disposed on the first surface SF1 of the base layer BSL.

The pixel circuit layer PCL may include at least one transistor, and a plurality of conductive lines connected to the transistor. Furthermore, the pixel circuit layer PCL may include a buffer layer BFL, a first gate insulating layer GI1, a second gate insulating layer GI2, an interlayer insulating layer ILD, a first via layer VIA1, and a second via layer VIA2 that are successively stacked on one surface of the base layer BSL.

The buffer layer BFL may be disposed on the base layer BSL to cover the base layer BSL. The buffer layer BFL may prevent external impurities from diffusing into the pixel circuit layer PCL. The buffer layer BFL may include at least one of silicon nitride (SiNₓ), silicon oxide (SiOₓ), silicon oxynitride (SiOₓN_{y}), and metal oxide such as aluminum oxide (AlOₓ). In some embodiments, the buffer layer BFL may be omitted. Furthermore, a bottom metal layer (not illustrated) may be disposed between the base layer BSL and the buffer layer BFL.

The first transistor T1 may include a first semiconductor pattern ACT1, a first gate electrode GE1, a first source electrode S1, and a first drain electrode D1.

The first semiconductor pattern ACT1 may be disposed on the buffer layer BFL. The first semiconductor pattern ACT1 may include a channel area, and a source area and a drain area that are disposed on opposite sides of the channel area. The source area of the first semiconductor pattern ACT1 may be electrically connected to the first source electrode S1, and the drain area thereof may be electrically connected to the first drain electrode D1. In other words, the source area and the drain area may extend and be electrically connected to electrodes of another layer through contact holes, respectively.

The first semiconductor pattern ACT1 may include at least one of polysilicon, amorphous silicon, and an oxide semiconductor.

The first gate insulating layer GI1 may be disposed on the first semiconductor pattern ACT1 and the buffer layer BFL. The first gate insulating layer GI1 may cover the first semiconductor pattern ACT1 and the buffer layer BFL.

The first gate insulating layer GI1 may include inorganic material. For example, the first gate insulating layer GI1 may include at least one of silicon nitride (SiNₓ), silicon oxide (SiOₓ), silicon oxynitride (SiOₓN_{y}), and aluminum oxide (AlOₓ). In an embodiment, the first gate insulating layer GI1 may include organic material.

The first gate electrode GE1 may be disposed on the first gate insulating layer GI1. The first gate electrode GE1 may be disposed to overlap the channel area of the first semiconductor pattern ACT1.

The driving voltage line DVL may be disposed on the first gate insulating layer GI1. The driving voltage line DVL may be physically and/or electrically connected with a bridge electrode BRD through a second contact hole CH2. Since the bridge electrode BRD may be physically and/or electrically connected with a second electrode EL2, the driving voltage line DVL may transmit a voltage of a second driving power supply (e.g., VSS) to the second electrode EL2 through the bridge electrode BRD. Although the driving voltage line DVL is illustrated as being disposed on the same layer as that of the first gate electrode GE1, the present disclosure is not limited thereto.

The second gate insulating layer GI2 may be disposed on the first gate electrode GE1 and the first gate insulating layer GI1. The second gate insulating layer GI2 may cover the first gate electrode GE1 and the first gate insulating layer GI1.

The second gate insulating layer GI2 may include the same material as that of the first gate insulating layer GI1 and, for example, include at least one of silicon nitride (SiNₓ), silicon oxide (SiOₓ), silicon oxynitride (SiOₓN_{y}), and aluminum oxide (AlOₓ).

The second gate electrode GE2 may be disposed on the second gate insulating layer GI2. The second gate electrode GE2 may be disposed to overlap the first gate electrode GE1. Hence, the first gate electrode GE1 and the second gate electrode GE2 that overlap each other with the second gate insulating layer GI2 interposed therebetween may form one storage capacitor Cst.

The interlayer insulating layer ILD may be disposed on the second gate insulating layer GI2. The interlayer insulating layer ILD may cover the second gate insulating layer GI2. The interlayer insulating layer ILD may be formed of an inorganic insulating layer including inorganic material. For example, the interlayer insulating layer ILD may include at least one of silicon nitride (SiNₓ), silicon oxide (SiOₓ), silicon oxynitride (SiOₓN_{y}), and metal oxides such as aluminum oxide (AlOₓ). The present disclosure is not limited to the foregoing embodiments. In an embodiment, the interlayer insulating layer ILD may be formed of an organic insulating layer including organic material.

The first source electrode S1 and the first drain electrode D1 may be disposed on the interlayer insulating layer ILD.

The first drain electrode D1 may be electrically connected to a first electrode EL1 of the display element layer DPL through a first contact hole CH1 that is formed in the passivation layer PSV and the second via layer VIA2 to be described below.
Hence, the first transistor T1 may transmit the voltage of the first driving power supply (e.g., VDD) to the first electrode EL1.

The first via layer VIA1 may be disposed on the interlayer insulating layer ILD. The first via layer VIA1 may cover a partial area of the interlayer insulating layer ILD. The first via layer VIA1 may be referred to as a dam structure, a pixel defining layer, or a bank that defines an emission area.

The first via layer VIA1 may include at least one organic insulating layer. The first via layer VIA1 may be formed of a single layer or multiple layers, and include inorganic insulating material or organic insulating material. For example, the first via layer VIA1 may include at least one of polyacrylates resin, epoxy resin, phenolic resin, polyamides resin, and polyimides resin.

The bridge electrode BRD may be disposed on the interlayer insulating layer ILD and the first via layer VIA1. The bridge electrode BRD may be bent in the third direction DR3 in a shape corresponding to the shape of the first via layer VIA1. The bridge electrode BRD may be physically and/or electrically connected with the driving voltage line DVL through the second contact hole CH2 that is formed in the second gate insulating layer GI2 and the interlayer insulating layer ILD. Although there is illustrated the case where the bridge electrode BRD is disposed on the same layer as that of the first source electrode S1 and the first drain electrode D1 of the first transistor T1, the present disclosure is not limited thereto.

The passivation layer PSV may be disposed on the first source electrode S1, the first drain electrode D1, the interlayer insulating layer ILD, and the bridge electrode BRD. The passivation layer PSV may cover the entirety of the first source electrode S1 and the first drain electrode D1, and partially cover the interlayer insulating layer ILD and the bridge electrode BRD.

The passivation layer PSV may be an organic insulating layer, an inorganic insulating layer, or an organic insulating layer on an inorganic insulating layer. For example, the inorganic insulating layer may include at least one of silicon oxide (SiOₓ), silicon nitride (SiNₓ), silicon oxynitride (SiOₓN_{y}), and metal oxide such as aluminum oxide (AlOₓ). The organic insulating layer may include, for example, at least one of polyacrylates resin, epoxy resin, phenolic resin, polyamides resin, polyimides resin, unsaturated polyesters resin, poly-phenylen ethers resin, poly-phenylene sulfides resin, and benzocyclobutene resin.

The second via layer VIA2 may be disposed on the passivation layer PSV and the bridge electrode BRD. The second via layer VIA2 may partially cover the passivation layer PSV and the bridge electrode BRD to have at least one opening OP. In other word, in the opening OP of the second via layer VIA2 that partially exposes an upper surface of the bridge electrode BRD, the second electrode EL2 and the bridge electrode BRD may be physically and/or electrically connected. Here, the second via layer VIA2 may be referred to as a dam structure.

The second via layer VIA2 may be partially disposed in the display element layer DPL depending on the height of an upper surface of the second via layer VIA2 that is defined in the third direction DR3. The second electrode EL2 may be disposed on the upper surface of the second via layer VIA2 that is disposed in the display element layer DPL.

The second via layer VIA2 may include at least one organic insulating layer. The second via layer VIA2 may be formed of a single layer or multiple layers, and include an inorganic insulating material or an organic insulating material. For example, the second via layer VIA2 may include at least one of polyacrylates resin, epoxy resin, phenolic resin, polyamides resin, and polyimides resin.

The display element layer DPL may include the first electrode EL1, a coupling electrode CP, light emitting elements LD, a protective layer PVX, and the second electrode EL2.

The first electrode EL1 may be disposed on the second via layer VIA2. In other words, the first electrode EL1 may be disposed on the pixel circuit layer PCL.

The first electrode EL1 may contact the first end EP1 of each of the light emitting elements LD, and be electrically and/or physically connected to the first end EP1. The first electrode EL1 may be electrically connected to the first transistor T1 of the pixel circuit layer PCL through the first contact hole CH1. Here, the first electrode EL1 may be an anode.

The first electrode EL1 may include transparent conductive material having a certain reflectivity. For example, the first electrode EL1 may include conductive oxide such as indium tin oxide (ITO), indium zinc oxide (IZO), zinc oxide (ZnO), indium gallium zinc oxide (IGZO), and indium tin zinc oxide (ITZO), a conductive polymer such as PEDOT (poly(3,4-ethylenedioxythiophene)), or the like. Furthermore, the first electrode EL1 may include opaque metal which may reflect light emitted from the light emitting elements LD in the image display direction (e.g., the third direction DR3) of the display device. For example, the first electrode EL1 may further include metal such as magnesium (Mg), aluminum (Al), platinum (Pt), palladium (Pd), nickel (Ni), neodymium (Nd), iridium (Ir), chrome (Cr), titanium (Ti), molybdenum (Mo), and an alloy thereof.

The coupling electrode CP may be disposed on the first electrode EL1 and make a contact with the light emitting elements LD. The coupling electrode CP may be disposed between the first electrode EL1 and the light emitting elements LD and electrically connected to the first electrode EL1 and the light emitting elements LD. In other words, the coupling electrode CP may directly contact the first end EP1 of the light emitting element LD and electrically and/or physically connect the first electrode EL1 with the first ends EP1 of the light emitting elements LD.

The coupling electrode CP may function as a reflector that guides light emitted from the light emitting elements LD in the image display direction (e.g., the third direction DR3) of the display device. To this end, the coupling electrode CP may be formed of opaque conductive material having a certain reflectivity. The coupling electrode CP may include the same material as that of the first electrode EL1, or may include one or more materials selected from among materials exemplified as the constituent material of the first electrode EL1. For example, the coupling electrode CP may include metal such as copper (Cu), gold (Au), tin (Sn), and an alloy thereof, which may be bonded to each light emitting element LD.

The light emitting element LD may be disposed on the coupling electrode CP. The first end EP1 of the light emitting element LD may be disposed on the coupling electrode CP. The first end EP1 of the light emitting element LD may be electrically and/or physically connected to the coupling electrode CP.

The first end EP1 of the light emitting element LD may be disposed to face the coupling electrode CP. The second end EP2 of the light emitting element LD may be disposed to face the second electrode EL2.

The light emitting element LD may be disposed in the height direction (h) of the light emitting element LD between the coupling electrode CP and the second electrode EL2. The light emitting element LD illustrated in FIG. 14 may correspond to the above-described light emitting element LD of FIGS. 12 and 13. To simply illustrate the light emitting element LD, FIG. 14 illustrates that the diameter of the first end EP1 is the same as that of the second end EP2.

Furthermore, an insulating layer (not illustrated) that encloses a surface of the light emitting element LD other than the first end EP1 and the second end EP2 may be further disposed on a side surface of the light emitting element LD. The light emitting element LD may be more stably fixed on the coupling electrode CP by the insulating layer.

The protective layer PVX may be disposed on the second via layer VIA2, the first electrode EL1, the coupling electrode CP, and a portion of each light emitting element LD. The protective layer PVX may be disposed to cover a portion of the upper surface of the second via layer VIA2, and cover the entirety of the first electrode EL1 and the coupling electrode CP. Furthermore, the protective layer PVX may be disposed between the light emitting elements LD such that the second end EP2 of each light emitting element LD is exposed.

The protective layer PVX may include an inorganic insulating layer including inorganic material or an organic insulating layer including organic material. In an embodiment, the protective layer PVX may function as a planarization layer for mitigating a step difference between components disposed thereunder in the display element layer DPL. To this end, the protective layer PVX may be formed of an organic insulating layer including organic material.

The second electrode EL2 may be disposed on the light emitting elements LD, the protective layer PVX, and the second via layer VIA2. The second electrode EL2 may be disposed to cover the light emitting elements LD, the protective layer PVX, and the second via layer VIA2. Furthermore, the second electrode EL2 may be disposed to cover a portion of an upper surface of the passivation layer PSV.

The second electrode EL2 may include transparent conductive material having a certain reflectivity. For example, the second electrode EL2 may include conductive oxide such as indium tin oxide (ITO), indium zinc oxide (IZO), zinc oxide (ZnO), indium gallium zinc oxide (IGZO), and indium tin zinc oxide (ITZO), a conductive polymer such as PEDOT (poly(3,4-ethylenedioxythiophene)), or the like. However, the material of the second electrode EL2 is not limited to the foregoing embodiments.

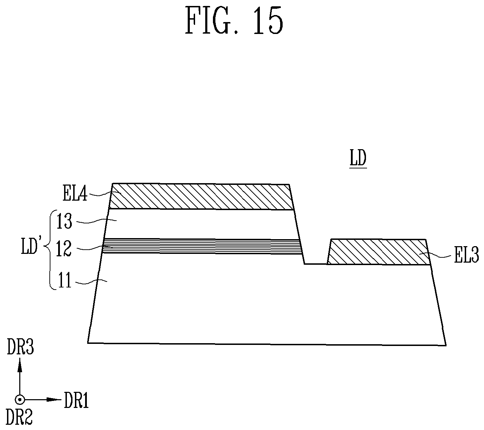

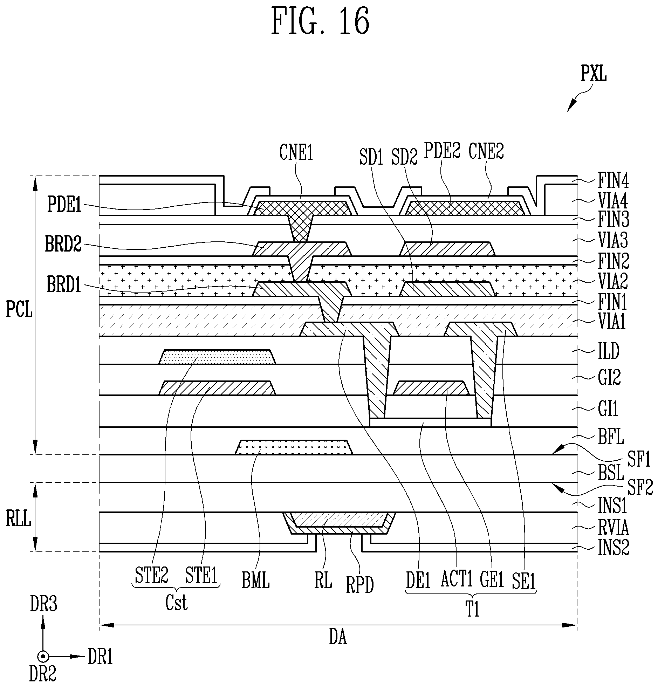

Hereinafter, the structure of a light emitting element in accordance with an embodiment will be described with reference to FIG. 15, and a display device in which the light emitting element of FIG. 15 may be disposed will be described with reference to FIG. 16.

FIG. 15 is a sectional view illustrating a light emitting element included in the display device in accordance with an embodiment. FIG. 16 is a sectional view schematically illustrating a pixel of the display device in accordance with an embodiment. A portion illustrated in FIG. 16 may correspond to a display area of the display device.

Referring to FIG. 15, a light emitting element LD in accordance with an embodiment may include a semiconductor structure LD', a third electrode EL3, and a fourth electrode EL4.

The semiconductor structure LD' may emit light by recombination of electrons and holes when current flows between the third electrode EL3 and the fourthelectrode EL4. Since light emission of the semiconductor structure LD' can be controlled by the current flows between the third electrode EL3 and the fourth electrode EL4, the light emitting element LD may be used as a light source (a light emitting source) of various light emitting devices.

The first semiconductor layer 11 may include, for example, at least one n-type semiconductor layer. For instance, the first semiconductor layer 11 may include an n-type semiconductor layer which includes any one semiconductor material of InAlGaN, GaN, AlGaN, InGaN, AlN, and InN and is doped with a first conductive dopant (or an n-type dopant) such as Si, Ge, or Sn. However, the constituent material of the first semiconductor layer 11 is not limited to thereto, and various other materials may be used to form the first semiconductor layer 11. In an embodiment, the first semiconductor layer 11 may include gallium nitride (GaN) semiconductor material doped with a first conductive dopant (or an n-type dopant).

The active layer 12 may be disposed on one side of the first semiconductor layer 11 and have a single or multiple quantum well structure. For example, in case that the active layer 12 is embodied as a multiple quantum well structure, the active layer 12 may be formed by stacking a barrier layer, a stain reinforcing layer, and a well layer which constitute one unit. The one unit may be periodically repeated in the active layer 12. The stain reinforcing layer may have a lattice constant less than that of the barrier layer so that strain, e.g., compressive strain, to be applied to the well layer can be further reinforced. However, the structure of the active layer 12 is not limited to that of the foregoing embodiment.

The active layer 12 may emit light having a wavelength ranging from 400 nm to 900 nm and have a double hetero structure. In an embodiment, a clad layer doped with a conductive dopant (not illustrated) may be formed over and/or under the active layer 12 with respect to the third direction DR3. For example, the cladding layer may be formed of an AlGaN layer or an InAlGaN layer. In an embodiment, material such as AlGaN or InAlGaN may be used to form the active layer 12, and various other materials may be used to form the active layer 12. The active layer 12 may include a first surface which contacts the first semiconductor layer 11, and a second surface which contacts the second semiconductor layer 13.

The second semiconductor layer 13 may be disposed on the second surface of the active layer 12 and provide holes to the active layer 12. The second semiconductor layer 13 may include a semiconductor layer having a type different from that of the first semiconductor layer 11. For example, the second semiconductor layer 13 may include at least one p-type semiconductor layer. For instance, the second semiconductor layer 13 may include a p-type semiconductor layer which includes any one semiconductor material of InAlGaN, GaN, AlGaN, InGaN, AlN, and InN, and is doped with a second conductive dopant (or a p-type dopant) such as Mg. However, the material for forming the second semiconductor layer 13 is not limited thereto and various other materials may be used to form the second semiconductor layer 13. In an embodiment, the second semiconductor layer 13 may include gallium nitride (GaN) semiconductor material doped with a second conductive dopant (or a p-type dopant). The second semiconductor layer 13 may include, with respect to the third direction DR3, a lower surface that contacts the second surface of the active layer 12, and an upper surface that contacts the fourth electrode EL4.

The first semiconductor layer 11, the active layer 12, and the second semiconductor layer 13 may be provided to have a structure such that they are successively stacked on a semiconductor substrate. Here, the semiconductor substrate may be formed of a sapphire substrate, a silicon substrate, or the like, including semiconductor material. The semiconductor substrate may be used as a growth substrate for growing each of the first semiconductor layer 11, the active layer 12, and the second semiconductor layer 13, and then removed from the first semiconductor layer 11 through a substrate removal process. Here, the substrate removal process may be a laser lift off process, a chemical lift off process, or the like. Consequently, as the growth semiconductor substrate is removed from the semiconductor structure LD', the thickness of the semiconductor structure LD' may be reduced. The above-mentioned semiconductor structure LD' may have a small size corresponding to the micrometer scale, but the present disclosure is not limited thereto.

The semiconductor structure LD' may include a mesa interface. The mesa interface may be formed by removing respective portions of the second semiconductor layer 13, the active layer 12, and an upper portion of the first semiconductor layer 11 through an etching process. Here, the etching process may be, for example, a dry etching process.

The third electrode EL3 may be provided and/or formed on the semiconductor structure LD'. For example, the third electrode EL3 may be provided and/or formed on the first semiconductor layer 11 so that the third electrode EL3 is electrically separated from the active layer 12 and the second semiconductor layer 13. In an embodiment, the third electrode EL3 may contact a bump (not illustrated) for bonding of the light emitting element LD.

The fourth electrode EL4 may be provided and/or formed on the semiconductor structure LD'. For example, the fourth electrode EL4 may be provided and/or formed on the second semiconductor layer 13. In an embodiment, the fourth electrode EL4 may contact another bump (not illustrated) for bonding of the light emitting element LD.

The third electrode EL3 may be a contact electrode that makes an ohmic-contact with the first semiconductor layer 11. The fourth electrode EL4 may be a contact electrode that makes an ohmic-contact with the second semiconductor layer 13. In an embodiment, each of the third and fourth electrodes EL3 and EL4 may be a Schottky contact electrode. Furthermore, the third electrode EL3 may be a cathode, and the fourth electrode EL4 may be an anode.

The third electrode EL3 and the fourth electrode EL4 may include conductive material. For example, the third and fourth electrodes EL3 and EL4 may include opaque metal such as chrome (Cr), titanium (Ti), aluminum (Al), gold (Au), nickel (Ni), and alloys thereof, or oxides of the opaque metal described above, which are used alone or in combination, but the present disclosure is not limited thereto. In an embodiment, the third electrode EL3 and the fourth electrode EL4 each may also include transparent conductive oxide such as indium tin oxide (ITO), indium zinc oxide (IZO), zinc oxide (ZnO), indium gallium zinc oxide (IGZO), or indium tin zinc oxide (ITZO).

Referring to FIG. 16, the pixel PXL in accordance with an embodiment may include a base layer BSL, and a pixel circuit layer PCL and a rear line layer RLL that are disposed on the base layer BSL. Here, the base layer BSL and the pixel circuit layer PCL may respectively correspond to the base layer BSL and the pixel circuit layer PCL that are described with reference to FIG. 5.

The pixel circuit layer PCL may include a bottom metal layer BML, a first transistor T1, a storage capacitor Cst, a first bridge electrode BRD1, a first data electrode SD1, a second bridge electrode BRD2, a second data electrode SD2, a first pixel electrode PDE1, a second pixel electrode PDE2, a first contact electrode CNE1, a second contact electrode CNE2, and a plurality of insulating layers BFL, GI1, GI2, ILD, VIA1, VIA2, VIA3, VIA4, FIN1, FIN2, FIN3, and FIN4 that are disposed on a first surface SF1 of the base layer BSL.

The bottom metal layer BML may be disposed on the base layer BSL and at least partially overlap the first transistor T1 to be described below. For example, the bottom metal layer BML may be formed of one or combination selected from the group consisting of copper (Cu), molybdenum (Mo), tungsten (W), aluminum neodymium (AlNd), titanium (Ti), aluminum (Al), silver (Ag), and an alloy thereof.

The buffer layer BFL may be disposed on the base layer BSL and the bottom metal layer BML, and prevent impurities or the like from diffusing into a circuit element disposed on the buffer layer BFL. The buffer layer BFL may be an inorganic insulating layer formed of inorganic material. For example, the buffer layer BFL may include at least one of silicon nitride (SiNₓ), silicon oxide (SiOₓ), silicon oxynitride (SiOₓN_{y}), and metal oxide such as aluminum oxide (AlOₓ).

The first transistor T1 may include a first semiconductor pattern ACT1, a first source electrode SE1, a first drain electrode DE1, and a first gate electrode GE1.

The first semiconductor pattern ACT1, the first source electrode SE1, and the first drain electrode DE1 may be disposed on the buffer layer BFL.

The first semiconductor pattern ACT1 may include a channel area overlapping the first gate electrode GE1, a first source area, and a first drain area of the first transistor T1. The first source area may be a partial area of the first semiconductor pattern ACT1 and be electrically and/or physically connected to the first source electrode SE1 through a contact hole that is formed in the insulating layers GI1, GI2, and ILD. The first drain area may be a partial area of the first semiconductor pattern ACT1 and be electrically and/or physically connected to the first drain electrode DE1 through a contact hole that is formed in the insulating layers GI1, GI2, and ILD.

The first semiconductor pattern ACT1 may be a semiconductor pattern formed of poly silicon, amorphous silicon, an oxide semiconductor, or the like. For example, the first source area and the first drain area each may be formed of a semiconductor layer doped with a dopant, and the channel area may be formed of an undoped semiconductor layer. For example, an n-type dopant may be used as the dopant, but the present disclosure is not limited thereto.

The first gate electrode GE1 may be disposed on the first gate insulating layer GI1, and located to overlap the first semiconductor pattern ACT1. For example, the first gate electrode GE1 may have a single-layer structure formed of one or combination selected from the group consisting of copper (Cu), molybdenum (Mo), tungsten (W), aluminum neodymium (AlNd), titanium (Ti), aluminum (Al), silver (Ag), and an alloy thereof.

The first gate insulating layer GI1 may be disposed on the buffer layer BFL and the first semiconductor pattern ACT1. The first gate insulating layer GI1 may be formed of an inorganic insulating layer including inorganic material. For example, the first gate insulating layer GI1 may include at least one of oxides such as silicon oxide (SiOₓ), and aluminum oxide (AlOₓ), or nitride such as silicon nitride (SiNₓ) or silicon oxynitride (SiOₓN_{y}). The present disclosure is not limited to the foregoing embodiments. In an embodiment, the first gate insulating layer GI1 may be formed of an organic insulating layer including organic material.

The first storage electrode STE1 may be disposed on the first gate insulating layer GI1.

The second gate insulating layer GI2 may be disposed on the first gate insulating layer GI1, the first gate electrode GE1, and the first storage electrode STE1. The second gate insulating layer GI2 may be formed of an inorganic insulating layer including inorganic material. For example, the second gate insulating layer GI2 may include at least one of oxides such as silicon oxide (SiOₓ), and aluminum oxide (AlOₓ), or nitride such as silicon nitride (SiNₓ) or silicon oxynitride (SiOₓN_{y}). The present disclosure is not limited to the foregoing embodiments. In an embodiment, the second gate insulating layer GI2 may be formed of an organic insulating layer including organic material.

The second storage electrode STE2 may be disposed on the second gate insulating layer GI2 to overlap the first storage electrode STE1 and form the storage capacitor Cst along with the first storage electrode STE1.

The interlayer insulating layer ILD may be disposed on the second gate insulating layer GI2 and the second storage electrode STE2. The interlayer insulating layer ILD may be formed of an inorganic insulating layer including inorganic material. For example, the interlayer insulating layer ILD may include at least one of oxides such as silicon oxide (SiOₓ), and aluminum oxide (AlOₓ), or nitride such as silicon nitride (SiNₓ) or silicon oxynitride (SiOₓN_{y}). The present disclosure is not limited to the foregoing embodiments. In an embodiment, the interlayer insulating layer ILD may be formed of an organic insulating layer including organic material.

The first source electrode SE1 and the first drain electrode DE1 may be disposed on the interlayer insulating layer ILD. The first source electrode SE1 may be electrically and/or physically connected to the source area of the first semiconductor pattern ACT1 through a contact hole that passes through the interlayer insulating layer ILD, the second gate insulating layer GI2, and the first gate insulating layer GI1. The first drain electrode DE1 may be electrically and/or physically connected to the drain area of the first semiconductor pattern ACT1 through a contact hole that passes through the interlayer insulating layer ILD, the second gate insulating layer GI2, and the first gate insulating layer GI1. The first drain electrode DE1 may be electrically and/or physically connected to the first bridge electrode BRD1 to be described below. For example, the first source electrode SE1 and the first drain electrode DE1 each may have a single-layer structure formed of one or combination selected from the group consisting of copper (Cu), molybdenum (Mo), tungsten (W), aluminum neodymium (AlNd), titanium (Ti), aluminum (Al), silver (Ag), and an alloy thereof, or may have a double-layer or triple-layer structure that further includes molybdenum (Mo), titanium (Ti), copper (Cu), aluminum (Al), or silver (Ag).

The first via layer VIA1 may be disposed on the first source electrode SE1 and the first drain electrode DE1. The first via layer VIA1 may include at least one organic insulating layer. The first via layer VIA1 may be formed of a single layer or multiple layers, and include inorganic insulating material or organic insulating material. For example, the first via layer VIA1 may include at least one of polyacrylates resin, epoxy resin, phenolic resin, polyamides resin, and polyimides resin.

The first front insulating layer FIN1 may be disposed on the first via layer VIA1. The first front insulating layer FIN1 may be formed of an inorganic insulating layer including inorganic material. For example, the first front insulating layer FIN1 may include at least one of silicon nitride (SiNₓ), silicon oxide (SiOₓ), silicon oxynitride (SiOₓN_{y}), and metal oxide such as aluminum oxide (AlOₓ). The present disclosure is not limited to the foregoing embodiments. In an embodiment, the first front insulating layer FIN1 may be formed of an organic insulating layer including organic material.

The first bridge electrode BRD1 and the first data electrode SD1 may be disposed on the first front insulating layer FIN1. The first bridge electrode BRD1 may be electrically and/or physically connected to the first drain electrode DE1 through a contact hole that is formed in the first frontal insulating layer FIN1 and the first via layer VIA1. For example, the first data electrode SD1 may correspond to a data line, a driving voltage line, a driving low-voltage line, or the like. The first bridge electrode BRD1 and the first data electrode SD1 each may have a single-layer structure formed of one or combination selected from the group consisting of copper (Cu), molybdenum (Mo), tungsten (W), aluminum neodymium (AlNd), titanium (Ti), aluminum (Al), silver (Ag), and an alloy thereof, or may have a double-layer or triple-layer structure that further includes molybdenum (Mo), titanium (Ti), copper (Cu), aluminum (Al), or silver (Ag).

The second via layer VIA2 may be disposed on the first front insulating layer FIN1, the first bridge electrode BRD1, and the first data electrode SD1. The second via layer VIA2 may include at least one organic insulating layer. The second via layer VIA2 may be formed of a single layer or multiple layers, and include inorganic insulating material or organic insulating material. For example, the second via layer VIA2 may include at least one of polyacrylates resin, epoxy resin, phenolic resin, polyamides resin, and polyimides resin.

The second front insulating layer FIN2 may be disposed on the second via layer VIA2. The second front insulating layer FIN2 may be formed of an inorganic insulating layer including inorganic material. For example, the second front insulating layer FIN2 may include at least one of oxides such as silicon oxide (SiOₓ), and aluminum oxide (AlOₓ), or nitride such as silicon nitride (SiNₓ) or silicon oxynitride (SiOₓN_{y}). The present disclosure is not limited to the foregoing embodiments. In an embodiment, the second front insulating layer FIN2 may be formed of an organic insulating layer including organic material.

The second bridge electrode BRD2 and the second data electrode SD2 may be disposed on the second front insulating layer FIN2. The second bridge electrode BRD2 may be electrically and/or physically connected to the first bridge electrode BRD1 through a contact hole that is formed in the second frontal insulating layer FIN2 and the second via layer VIA2. For example, the second data electrode SD2 may correspond to a data line, a driving voltage line, a driving low-voltage line, or the like. The second bridge electrode BRD2 and the second data electrode SD2 each may have a single-layer structure formed of one or combination selected from the group consisting of copper (Cu), molybdenum (Mo), tungsten (W), aluminum neodymium (AlNd), titanium (Ti), aluminum (Al), silver (Ag), and an alloy thereof, or may have a double-layer or triple-layer structure that further includes molybdenum (Mo), titanium (Ti), copper (Cu), aluminum (Al), or silver (Ag).

The third via layer VIA3 may be disposed on the second front insulating layer FIN2, the second bridge electrode BRD2, and the second data electrode SD2. The third via layer VIA3 may include at least one organic insulating layer. The third via layer VIA3 may be formed of a single layer or multiple layers, and include inorganic insulating material or organic insulating material. For example, the third via layer VIA3 may include at least one of polyacrylates resin, epoxy resin, phenolic resin, polyamides resin, and polyimides resin.

The third front insulating layer FIN3 may be disposed on the third via layer VIA3. The third front insulating layer FIN3 may be formed of an inorganic insulating layer including inorganic material. For example, the third front insulating layer FIN3 may include at least one of oxides such as silicon oxide (SiOₓ), and aluminum oxide (AlOₓ), or nitride such as silicon nitride (SiNₓ) or silicon oxynitride (SiOₓN_{y}). The present disclosure is not limited to the foregoing embodiments. In an embodiment, the third front insulating layer FIN3 may be formed of an organic insulating layer including organic material.

The first pixel electrode PDE1 may be disposed on the third front insulating layer FIN3, and contact an upper surface of the second bridge electrode BRD2 that is exposed from the third front insulating layer FIN3 and the third via layer VIA3. Hence, the first pixel electrode PDE1 may be electrically and/or physically connected to the second bridge electrode BRD2, and electrically connected to the first drain electrode DE1 via the second bridge electrode BRD2 and the first bridge electrode BRD1. The first pixel electrode PDE1 may be electrically connected to the third electrode EL3 (refer to FIG. 15) of the light emitting element LD by a bump (not illustrated).

The second pixel electrode PDE2 may be disposed on the third front insulating layer FIN3. The second pixel electrode PDE2 and the first pixel electrode PDE1 each may have a single-layer structure formed of one or combination selected from the group consisting of copper (Cu), molybdenum (Mo), tungsten (W), aluminum neodymium (AlNd), titanium (Ti), aluminum (Al), silver (Ag), and an alloy thereof, or may have a double-layer or triple-layer structure that further includes molybdenum (Mo), titanium (Ti), copper (Cu), aluminum (Al), or silver (Ag). The second pixel electrode PDE2 may be electrically connected to the fourth electrode EL4 (refer to FIG. 15) of the light emitting element LD by a bump (not illustrated).

The first contact electrode CNE1 may be disposed on the first pixel electrode PDE1 to cover the first pixel electrode PDE1. The second contact electrode CNE2 may be disposed on the second pixel electrode PDE2 to cover the second pixel electrode PDE2. The first contact electrode CNE1 and the second contact electrode CNE2 each may include transparent conductive oxide. For instance, the first contact electrode CNE1 and the second contact electrode CNE2 may include indium tin oxide (ITO), indium zinc oxide (IZO), zinc oxide (ZnO), indium gallium zinc oxide (IGZO), indium tin zinc oxide (ITZO), or the like.

The fourth via layer VIA4 may be disposed on a portion of the third front insulating layer FIN3. The fourth via layer VIA4 allows an upper surface of the first contact electrode CNE1 and an upper surface of the second contact electrode CNE2 to be exposed. The fourth via layer VIA4 may be formed of a single layer or multiple layers, and include inorganic insulating material or organic insulating material. For example, the fourth via layer VIA4 may include at least one of polyacrylates resin, epoxy resin, phenolic resin, polyamides resin, and polyimides resin.

The fourth front insulating layer FIN4 may be disposed on the fourth via layer VIA4, the first contact electrode CNE1, and the second contact electrode CNE2. The fourth front insulating layer FIN4 may be disposed to allow a portion of an upper surface of the first contact electrode CNE1 and a portion of an upper surface of the second contact electrode CNE2 to be exposed. The exposed portion of the upper surface of the first contact electrode CNE1 may be electrically connected to the third electrode EL3 of the light emitting element LD by a bump. The exposed portion of the upper surface of the second contact electrode CNE2 may be electrically connected to the third electrode EL3 of the light emitting element LD by a bump.

The rear line layer RLL may include a rear line RL, a rear pad electrode RPD, a first insulating layer INS1, a second insulating layer INS2, and a rear via layer RVIA that are disposed on a second surface SF2 of the base layer BSL. In an embodiment, the planarization layer PLL described with reference to FIG. 7 may be disposed between the base layer BSL and the first insulating layer INS1.

The rear line RL, the rear pad electrode RPD, and the first insulating layer INS1 that form the rear line layer RLL may be the same as the configuration described with reference to FIG. 7; therefore, redundant description thereof will be omitted.

The rear via layer RVIA may be disposed on the first insulating layer INS1 and located to cover the rear line RL and the rear pad electrode RPD. The rear via layer RVIA may be disposed to cover the rear pad electrode RPD such that at least a portion of the upper surface of the rear pad electrode RPD may be exposed. The rear via layer RVIA may be formed of a single layer or multiple layers, and include inorganic insulating material or organic insulating material. For example, the rear via layer RVIA may include at least one of polyacrylates resin, epoxy resin, phenolic resin, polyamides resin, and polyimides resin.

The second insulating layer INS2 may be disposed to cover the rear via layer RVIA and cover a portion of the rear pad electrode RPD. The second insulating layer INS2 may cover the rear pad electrode RPD such that at least a portion of the upper surface of the rear pad electrode RPD may be exposed. The second insulating layer INS2 may cover an upper surface and side surfaces of the rear via layer RVIA.

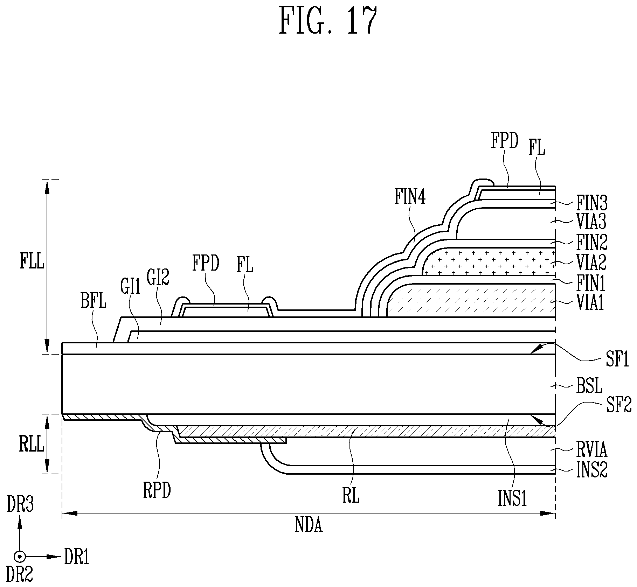

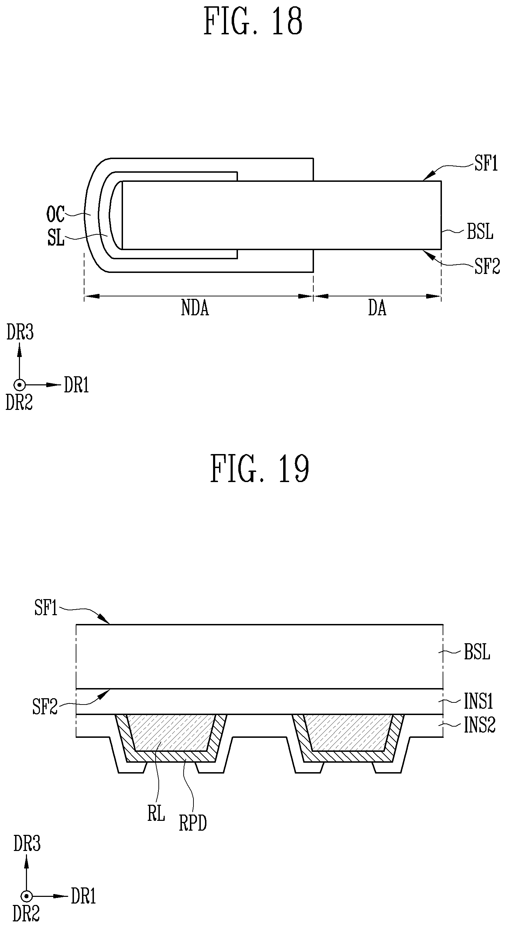

Hereinafter, the structure of the display device will be described with reference to FIGS. 17 and 18.

FIG. 17 is a sectional view schematically illustrating a portion of the non-display area of the display device in accordance with an embodiment. FIG. 18 is a sectional view schematically illustrating the display area and the non-display area of the display device in accordance with an embodiment.

Referring to FIG. 17, the display device in accordance with an embodiment may include a front line layer FLL and a rear line layer RLL that are disposed on the base layer BSL. Unlike the illustration of FIG. 16, the illustration of FIG. 17 is focused on the non-display area NDA. The rear line layer RLL illustrated in FIG. 17 may include a configuration identical or similar to that of the rear line layer RLL of FIG. 16. In the following description of the configuration illustrated in FIG. 17, description of the same parts as that of the configuration of FIG. 16 will be simplified.

The front line layer FLL may include a buffer layer BFL, a front line FL, a front pad electrode FPD, and a plurality of insulating layers GI1, GI2, VIA1, VIA2, VIA3, FIN1, FIN2, FIN3, and FIN4 that are disposed on the first surface SF1 of the base layer BSL.

The buffer layer BFL may be disposed on the base layer BSL and include an inorganic insulating layer formed of inorganic material.

The first gate insulating layer GI1 may be disposed on the buffer layer BFL and cover at least a portion of an upper surface of the buffer layer BFL. The first gate insulating layer GI1 may be formed of an inorganic insulating layer including inorganic material.

The second gate insulating layer GI2 may be disposed on the first gate insulating layer GI1 and cover a portion of the upper surface of the buffer layer BFL along with the first gate insulating layer GI1. The second gate insulating layer GI2 may be formed of an inorganic insulating layer including inorganic material.

The first via layer VIA1 may be disposed on a portion of the second gate insulating layer GI2, and include at least one organic insulating layer.

The first front insulating layer FIN1 may be disposed on the first via layer VIA1 to cover the first via layer VIA1. The first front insulating layer FIN1 may be formed of an inorganic insulating layer including inorganic material.

The second via layer VIA2 may be disposed on a portion of the first front insulating layer FIN1 and include at least one organic insulating layer.

The second front insulating layer FIN2 may be disposed on the second via layer VIA2 and the first front insulating layer FIN1 to cover the second via layer VIA2 and the first front insulating layer FIN1. The second front insulating layer FIN2 may be formed of an inorganic insulating layer including inorganic material.

The third via layer VIA3 may be disposed on a portion of the second front insulating layer FIN2 and include at least one organic insulating layer.

The third front insulating layer FIN3 may be disposed on the third via layer VIA3 and the second front insulating layer FIN2 to cover the third via layer VIA3 and the second front insulating layer FIN2. The third front insulating layer FIN3 may be formed of an inorganic insulating layer including inorganic material.

The front line FL may be disposed on the second gate insulating layer GI2 and/or the third front insulating layer FIN3. The front line FL may correspond to a data line, a gate line, a driving voltage line, a driving low-voltage line, a pad line, or the like that is provided in the non-display area NDA. The front line FL may have a single-layer structure formed of one or combination selected from the group consisting of copper (Cu), molybdenum (Mo), tungsten (W), aluminum neodymium (AlNd), titanium (Ti), aluminum (Al), silver (Ag), and an alloy thereof, or may have a double-layer or triple-layer structure that further includes molybdenum (Mo), titanium (Ti), copper (Cu), aluminum (Al), or silver (Ag).

The front pad electrode FPD may be disposed on the front line FL to cover the front line FL. The front pad electrode FPD may include transparent conductive oxide. For instance, the front pad electrode FPD may include indium tin oxide (ITO), indium zinc oxide (IZO), zinc oxide (ZnO), indium gallium zinc oxide (IGZO), indium tin zinc oxide (ITZO), or the like.

The fourth front insulating layer FIN4 may be disposed on the front pad electrode FPD, the third front insulating layer FIN3, and the second gate insulating layer GI2 to cover the front pad electrode FPD, the third front insulating layer FIN3, and the second gate insulating layer GI2. The fourth front insulating layer FIN4 may cover the front pad electrode FPD such that at least a portion of an upper surface of the front pad electrode FPD is exposed. The fourth front insulating layer FIN4 may be formed of an inorganic insulating layer including inorganic material.

The rear line layer RLL may include a first insulating layer INS1, a rear line RL, a rear pad electrode RPD, a rear via layer RVIA, and a second insulating layer INS2 that are disposed on a second surface SF2 of the base layer BSL. In an embodiment, the planarization layer PLL described with reference to FIG. 7 may be disposed between the base layer BSL and the first insulating layer INS1.

The first insulating layer INS1 may be disposed on a portion of the base layer BSL.

The rear line RL may be disposed on a portion of the first insulating layer INS1. The rear pad electrode RPD may be disposed on the rear line RL, the first insulating layer INS1, and the base layer BSL to cover at least a portion of the rear line RL, at least a portion of the first insulating layer INS1, and a portion of the base layer BSL.

The rear via layer RVIA may be disposed on the rear line RL and located to cover at least respective portions of the rear line RL and the rear pad electrode RPD.

The second insulating layer INS2 may be disposed on the rear via layer RVIA and located to cover respective portions of the rear via layer RVIA and the rear pad electrode RPD.

Referring to FIG. 18, the display device in accordance with an embodiment may include lines SL configured to electrically connect the lines, the pad electrodes, and the like disposed on the first surface SF1 and the second surface SF2 of the base layer BSL, and may further include an overcoat layer OC configured to protect the lines and the pad electrodes, and the like that are disposed in the non-display area NDA. Here, in the non-display area NDA, the front line layer FLL and the rear line layer RLL that are described with reference to FIG. 17 may be disposed. In the display area DA, the pixel circuit layer PCL described with reference to FIG. 16 may be disposed.

The lines SL may be disposed to cover the first surface SF1 and the second surface SF2 of the base layer BSL and one side surface of the base layer BSL. Hence, the lines SL may electrically connect the front line, the front pad electrode, and the like that are disposed on the first surface SF1 with the rear line, the rear pad electrode, and the like that are disposed on the second surface SF2.

The overcoat layer OC may be disposed to cover the lines SL, the first surface SF1 and the second surface SF2 of the base layer BSL, and one side surface of the base layer BSL. The overcoat layer OC may include organic material such as polyacrylates resin, epoxy resin, phenolic resin, polyamides resin, polyimides resin, unsaturated polyesters resin, poly-phenylen ethers resin, poly-phenylene sulfides resin, and benzocyclobutene resin.

Hereinafter, another structure of the display device in accordance with an embodiment will be described with reference to FIG. 19.

FIG. 19 is a sectional view of the display device in accordance with an embodiment.

Referring to FIG. 19, the display device in accordance with an embodiment may include a base layer BSL, a first insulating layer INS1, a rear line RL, a rear pad electrode RPD, and a second insulating layer INS2. The display device illustrated in FIG. 19 is similar to the display device illustrated in FIG. 7; therefore, the following description will be focused on differences therebetween.

The above-mentioned pixel circuit layer PCL (refer to FIG. 16), the display element layer, and the like may be disposed on the first surface SF1 of the base layer BSL.

The first insulting layer INS1 may be disposed on the second surface SF2 of the base layer BSL. The first insulting layer INS1 may cover the entirety of the second surface SF2 of the base layer BSL.

The first insulating layer INS1 may be formed of an inorganic insulating layer including inorganic material (or substance). Furthermore, the first insulating layer INS1 may include transparent inorganic insulating material.

The rear line RL may be disposed on the first insulating layer INS1.

The rear pad electrode RPD may be disposed on the rear line RL. The rear pad electrode RPD may be disposed on the rear line RL and the first insulating layer INS1 so that the rear line RL may be covered with the rear pad electrode RPD.

The second insulating layer INS2 may be disposed on the rear pad electrode RPD. The second insulating layer INS2 may cover the rear pad electrode RPD such that at least a portion of an upper surface of the rear pad electrode RPD is exposed, and may cover the first insulating layer INS1. A circuit substrate or the like may be attached to the upper surface of the rear pad electrode RPD that is exposed from the second insulating layer INS2.

The second insulating layer INS2 may be formed of an inorganic insulating layer including inorganic material.

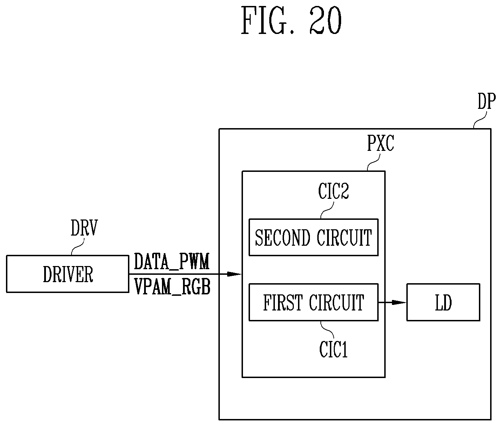

Hereinafter, a configuration of the display device, a structure of a pixel, and a method of driving the pixel in accordance with an embodiment will be described with reference to FIGS. 20 to 22.

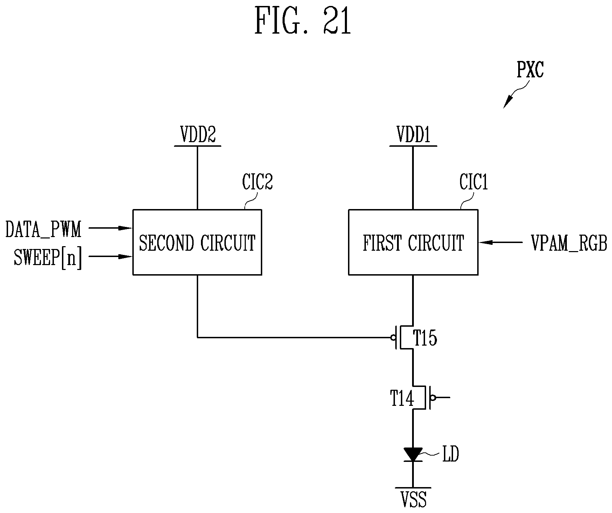

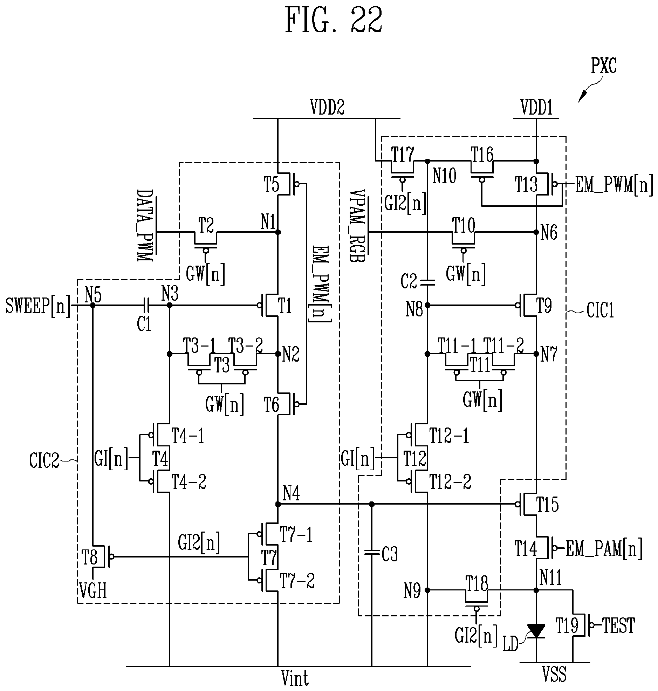

FIG. 20 is a block diagram schematically illustrating the configuration of the display device in accordance with an embodiment. FIG. 21 is a diagram schematically illustrating a pixel circuit of the display device in accordance with an embodiment. FIG. 22 is a circuit diagram illustrating a pixel circuit of the display device in accordance with an embodiment.

Referring to FIG. 20, the display device in accordance with an embodiment may include a display panel DP and a driver DRV configured to drive the display panel DP.

The display panel DP may include a pixel circuit PXC and a light emitting element LD. The pixel circuit PXC may be formed of the elements of the pixel circuit layer PCL that are described with reference to FIG. 16.

The pixel circuit PXC may provide driving current to the light emitting element LD. In detail, the pixel circuit PXC may provide, to the light emitting element LD, driving current corresponding to data voltages (e.g., VPAM_RGB and DATA_PWM) applied from the driver DRV and controlled in level and driving time, driving voltages (e.g., VDD1 and VDD2), and various control signals. Hence, the light emitting element LD may express gray scale values having different luminances depending on the level or pulse width of driving signal provided from the pixel circuit PXC. In other words, the pixel circuit PXC may drive the light emitting element LD in a pulse amplitude modulation (PAM) and/or pulse width modulation (PWM) driving scheme so that the luminance of light emitted from the light emitting element LD can be controlled. Here, the light emitting element LD may correspond to the light emitting element illustrated in FIGS. 12 and 13, or may also correspond to the light emitting element illustrated in FIG. 15.

The pixel circuit PXC may include a first circuit CIC1 configured to provide a certain level of constant current to the light emitting element LD based on a PAM voltage VPAM_RGB, and a second circuit CIC2 configured to provide the constant current from the first circuit CIC1 to the light emitting element LD during a period corresponding to a PWM voltage DATA_PWM.

The driver DRV may provide a PWM voltage DATA_PWM corresponding to a gray scale value of each pixel to the second circuit CIC2 of the display panel DP. Consequently, a driving time of driving current (i.e., constant current) to be provided to the light emitting element LD of each pixel through the second circuit CIC2 may be controlled. Hence, gray scales of images of the display device may be embodied in various ways. The same PAM voltage VPAM_RGB may be applied to each display device (or each display panel) that forms the plurality of display devices described with reference to FIG. 1, or different levels of PAM voltages VPAM_RGB may be applied to the display devices.

Referring to FIG. 21, the pixel circuit PXC in accordance with an embodiment may include a first circuit CIC1, a second circuit CIC2, a fifteenth transistor T15 (or a first switching transistor), a fourteenth transistor T14 (or a second switching transistor), and a light emitting element LD.

The first circuit CIC1 may provide constant current having a constant level to the light emitting element LD. Furthermore, the first circuit CIC1 may include a compensation transistor configured to compensate for a threshold voltage of a driving transistor included in the first circuit CIC1. Hence, the first circuit CIC1 may provide driving current having a level corresponding to the PAM voltage VPAM_RGB to the light emitting element LD, regardless of the threshold voltage of the driving transistor.

The second circuit CIC2 may control a turn-on or turn-off operation of the fifteenth transistor T15 to control a period during which constant current flows to the light emitting element LD. The second circuit CIC2 may include a compensation transistor configured to compensate for a threshold voltage of a driving transistor included in the second circuit CIC2. Furthermore, the second circuit CIC2 may change a gate voltage of the driving transistor depending on a sweep voltage SWEEP[n] applied thereto. Hence, the second circuit CIC2 may provide driving current having a level corresponding to the PWM voltage DATA_PWM to the light emitting element LD, regardless of the threshold voltage of the driving transistor. Furthermore, the second circuit CIC2 may change a gate voltage of the fifteenth transistor T15 to control a turn-on or turn-off time point of the fifteenth transistor T15.

The fifteenth transistor T15 may be turned on or off in response to a control signal of the driver DRV. To be more specific, a driving time point of the fifteenth transistor T15 may be controlled by the driving current supplied from the second circuit CIC2. The turn-on or turn-off timing of the fifteenth transistor T15 may be related to implementation of a black gray scale.

Referring to FIG. 22, the pixel circuit PXC in accordance with an embodiment may include a first circuit CIC1, a second circuit CIC2, a fifteenth transistor T15, a fourteenth transistor T14, a nineteenth transistor T19, and a light emitting element LD.

The second circuit CIC2 may include a first transistor T1, a second transistor T2, a third transistor T3, a fourth transistor T4, a fifth transistor T5, a sixth transistor T6, a seventh transistor T7, an eighth transistor T8, and a first capacitor C1.

The first transistor T1 may include a first electrode connected to a first node N1, a second electrode connected to a second node N2, and a gate electrode connected to a third node N3. The first transistor T1 may be a driving transistor of the second circuit CIC2.

The second transistor TP2 may include a first electrode connected to a PWM voltage DATA_PWM, a second electrode connected to the first node N1, and a gate electrode connected to a first gate line GW[n]. When the second transistor T2 is turned on, the PWM voltage DATA_PWM may be supplied to the first node N1.

The third transistor T3 may include two transistors T3-1 and T3-2 connected in series to each other. A first electrode of the 3-1-th transistor T3-1 may be connected to the third node N3. A second electrode of the 3-2-th transistor T3-2 may be connected to the second node N2. A second electrode of the 3-1-th transistor T3-1 may be connected to a first electrode of the 3-2-th transistor T3-2. A gate electrode of the 3-1-th transistor T3-1 and a gate electrode of the 3-2-th transistor T3-2 may be connected to the first gate line GW[n].

The fourth transistor T4 may include two transistors T4-1 and T4-2 connected in series to each other. A first electrode of the 4-1-th transistor T4-1 may be connected to the third node N3. A second electrode of the 4-2-th transistor T4-2 may be connected to an initialization power supply Vint. A second electrode of the 4-1-th transistor T4-1 may be connected to a first electrode of the 4-2-th transistor T4-2. A gate electrode of the 4-1-th transistor T4-1 and a gate electrode of the 4-2-th transistor T4-2 may be connected to a second gate line GI[n].

The fifth transistor T5 may include a first electrode connected to a second driving voltage VDD2, a second electrode connected to the first node N1, and a gate electrode connected to an emission PWM line EM_PWM[n].

The sixth transistor T6 may include a first electrode connected to the second node N2, a second electrode connected to a fourth node N4, and a gate electrode connected to the emission PWM line EM_PWM[n].

The seventh transistor T7 may include two transistors T7-1 and T7-2 connected in series to each other. A first electrode of the 7-1-th transistor T7-1 may be connected to the fourth node N4. A second electrode of the 7-2-th transistor T7-2 may be connected to the initialization power supply Vint. A second electrode of the 7-1-th transistor T7-1 may be connected to a first electrode of the 7-2-th transistor T7-2. A gate electrode of the 7-1-th transistor T7-1 and a gate electrode of the 7-2-th transistor T7-2 may be connected to a third gate line GI2[n].

The eighth transistor T8 may include a first electrode connected to a fifth node N5 which receives a sweep voltage SWEEP[n], a second electrode connected to a reference voltage VGH, and a gate electrode connected to a third gate line GI2[n].

The first capacitor C1 may include a first electrode connected to the fifth node N5 and a second electrode connected to the third node N3. The first capacitor C1 may vary the voltage of the third node N3 depending on variation in the sweep voltage SWEEP[n].

The first circuit CIC1 may include a ninth transistor T9, a tenth transistor T10, an eleventh transistor T11, a twelfth transistor T12, a thirteenth transistor T13, a sixteenth transistor T16, a seventeenth transistor T17, an eighteenth transistor T18, a second capacitor C2, and a third capacitorC3.

The ninth transistor T9 may include a first electrode connected to a sixth node N6, a second electrode connected to a seventh node N7, and a gate electrode connected to an eighth node N8. The ninth transistor T9 may be a driving transistor of the first circuit CIC1.

The tenth transistor T10 may include a first electrode connected to a PAM voltage VPAM_RGB, a second electrode connected to the sixth node N6, and a gate electrode connected to the first gate line GW[n]. When the tenth transistor T10 is turned on, the PAM voltage VPAM_RGB may be supplied to the sixth node N6.

The eleventh transistor T11 may include two transistors T11-1 and T11-2 connected in series to each other. A first electrode of the 11-1-th transistor T11-1 may be connected to the eighth node N8. A second electrode of the 11-2-th transistor T11-2 may be connected to the seventh node N7. A second electrode of the 11-1-th transistor T11-1 may be connected to a first electrode of the 11-2-th transistor T11-2. A gate electrode of the 11-1-th transistor T11-1 and a gate electrode of the 11-2-th transistor T11-2 may be connected to the first gate line GW[n].

The twelfth transistor T12 may include two transistors T12-1 and T12-2 connected in series to each other. A first electrode of the 12-1-th transistor T12-1 may be connected to the eighth node N8. A second electrode of the 12-2-th transistor T12-2 may be connected to a ninth node N9. A second electrode of the 12-1-th transistor T12-1 may be connected to a first electrode of the 12-2-th transistor T12-2. A gate electrode of the 12-1-th transistor T12-1 and a gate electrode of the 12-2-th transistor T12-2 may be connected to the second gate line GI[n].

The thirteenth transistor T13 may include a first electrode connected to the first driving voltage VDD1, a second electrode connected to the sixth node N6, and a gate electrode connected to the emission PWM line EM_PWM[n].

The sixteenth transistor T16 may include a first electrode connected to a tenth node N10, a second electrode connected to the first driving voltage VDD1, and a gate electrode connected to the emission PWM line EM_PWM[n].

The seventeenth transistor T17 may include a first electrode connected to the second driving voltage VDD2, a second electrode connected to the tenth node N10, and a gate electrode connected to the third gate line GI2[n].

The eighteenth transistor T18 may include a first electrode connected to the ninth node N9, a second electrode connected to the eleventh node N11, and a gate electrode connected to the third gate line GI2[n].

The second capacitor C2 may include a first electrode connected to the tenth node N10, and a second electrode connected to the eighth node N8.

The third capacitor C3 may include a first electrode connected to the fourth node N4, and a second electrode connected to the initialization power supply Vint.

The nineteenth transistor T19 may include a first electrode connected to an eleventh node N11, a second electrode connected to a low driving voltage VSS, and a gate electrode connected to a test line TEST. The nineteenth transistor T19 may be turned on in response to a test voltage before the light emitting element LD is electrically connected to the pixel circuit PXC, so as to check whether the pixel circuit PXC malfunctions or not.

The method of driving the pixel circuit PXC will be described below.

First, if a turn-on voltage (a logic low level) is applied to the third gate line GI2[n], the seventh transistor T7, the eighth transistor T8, the seventeenth transistor T17, and the eighteenth transistor T18 may be turned on. Hence, the voltage of the initialization power supply Vint may be applied to the fourth node N4 and the eleventh node N11, the reference voltage VGH may be applied to the fifth node N5, and the second driving voltage VDD2 may be applied to the tenth node N10. Here, the anode of the light emitting element LD may be initialized to the voltage of the initialization power supply Vint.

After the turn-on voltage has been applied to the third gate line GI2[n], a turn-on voltage (a logic low level) is applied to the first gate line GW[n] so that the second transistor T2, the third transistor T3, the tenth transistor T10, and the eleventh transistor T11 may be turned on. Hence, the PWM voltage DATA_PWM is applied to the first node N1, and a different in voltage between the first node N1 and the second node N2 is set to be less than the threshold voltage of the first transistor T1, so that the first transistor T1 may be turned on. The PAM voltage VPAM_RGB is applied to the sixth node N6, and a different in voltage between the eighth node N8 and the seventh node N7 is set to be less than the threshold voltage of the ninth transistor T9, so that the ninth transistor T9 may be turned on.

If a turn-on voltage (a logic low level) is applied to the second gate line GI[n], the fourth transistor T4 and the twelfth transistor T12 may be turned on, and the voltage of the initialization power supply Vint may be applied to the third node N3 and the eighth node N8. A time point at which the turn-on voltage is applied to the second gate line GI[n] may be later than or the same as a time point at which the turn-on voltage is applied to the first gate line GW[n].

Thereafter, if a turn-on voltage (a logic low level) is applied to the emission PWM line EM_PWM[n], the fifth transistor T5, the sixth transistor T6, the thirteenth transistor T13, and the sixteenth transistor T16 may be turned on. Hence, in the second circuit CIC2, current corresponding to the second driving voltage VDD2 may be supplied to the fourth node N4. In the first circuit CIC1, current corresponding to the first driving voltage VDD1 may be applied to the seventh node N7.

If a turn-on voltage (a logic low level) is applied to the emission PAM line EM_PAM[n], the fourteenth transistor T14 may be turned on. Here, if a difference between the voltage of the fourth node N4 and the voltage of the first electrode of the fourteenth transistor T14 is set to be less than the threshold voltage of the fifteenth transistor T15, the fifteenth transistor T15 may be turned on. Consequently, driving current (or constant current) may flow from the first circuit CIC1 to the light emitting element LD, so that the light emitting element LD may emit light at a luminance corresponding to the level of the driving current.

If the turn-on voltage is applied to the emission PWM line EM_PWM[n], the sweep voltage SWEEP[n] may be linearly reduced during a certain period. Therefore, the voltage of the third node N3 may be reduced, and a voltage to be supplied to the fourth node N4 may correspond to the PWM voltage DATA_PWM. The voltage to be supplied to the fourth node N4 may be changed depending on the level of the PWM voltage DATA_PWM. In case that the PWM voltage DATA_PWM is increased, the voltage of the fourth node N4 may be increased, and the fifteenth transistor T15 may be turned off by a change in the voltage of the fourth node N4. In other words, the second circuit CIC2 may control turning on and off the fifteenth transistor T15 by changing the gate voltage of the fifteenth transistor T15. If the fifteenth transistor T15 is turned off, driving current does not flow to the light emitting element LD. Accordingly, the light emitting element LD does not emit light. In this way, the second circuit CIC2 may control an emission time of the light emitting element LD. In other words, the pixel circuit PXC may control an operation time of the fifteenth transistor T15 so that the emission time of the light emitting element LD can be controlled, and gray scale expressivity can be enhanced.

Although in an embodiment there has been described that the pixel circuit PXC is operated in the PAM driving scheme and the PWM driving scheme, the pixel circuit PXC may be operated in only the PAM driving scheme or only the PWM driving scheme.

In accordance with an embodiment, a planarization layer may be formed on one surface of a base layer, and then a rear line, a rear pad electrode, and the like may be formed on the planarization layer. Therefore, defects may be prevented from occurring on the rear line or the like, and structural stability of a display device may be secured.

The effects of the present disclosure are not limited by the foregoing embodiments, and other various effects are anticipated herein.

While various exemplary embodiments have been described above, those skilled in the art will appreciate that various modifications, additions and substitutions are possible without departing from the scope of the invention as defined by the claims.

## Claims

1. A display device comprising:
a base layer (BSL) including a first surface (SF1) and a second surface (SF2) that is opposite to the first surface (SF1);
a pixel circuit layer (PCL) disposed on the first surface (SF1);
a display element layer (DPL) disposed on the pixel circuit layer (PCL);
a first insulating layer (INS1) disposed on the second surface (SF2);
a planarization layer (PLL) disposed between the second surface (SF2) and the first insulating layer (INS1); and
a rear line (RL) disposed on the first insulating layer (INS1);
wherein the planarization layer (PLL) includes organic material, **characterised in that**
a rear pad electrode (RPD) is disposed on the rear line (RL) to cover the rear line (RL) and contact the first insulating layer (INS1).

2. The display device according to claim 1, further comprising:
a second insulating layer (INS2) covering the rear pad electrode (RPD) such that at least a portion of an upper surface of the rear pad electrode is exposed.

3. The display device according to claim 1 or 2, wherein the first insulating layer includes transparent inorganic insulating material.

4. The display device according to claim 1, 2 or 3, wherein the base layer comprises a rigid substrate.

5. The display device according to any one of the preceding claims, wherein the rear line extends on the second surface in a first direction.

6. The display device according to any one of the preceding claims, wherein the rear pad electrode includes transparent conductive oxide.

7. The display device according to any one of the preceding claims, wherein the pixel circuit layer includes a first transistor disposed on the first surface.

8. The display device according to any one of the preceding claims,
wherein the display element layer comprises a light emitting element, and
wherein the light emitting element comprises:
a first semiconductor layer;
a second semiconductor layer different from the first semiconductor layer; and
an active layer disposed between the first semiconductor layer and the second semiconductor layer.

9. A method of fabricating a display device, comprising:
preparing a base layer (BSL) including a first surface (SF1) and a second surface (SF2) that is opposite to the first surface (SF1);
forming a pixel circuit layer (PCL) and a display element layer (DPL) on the first surface (SF1);
forming a planarization layer (PLL) comprising organic material on the second surface (SF2);
forming a first insulating layer (INS1) on the planarization layer (PLL); and
forming a rear line (RL) and a rear pad electrode (RPD) on the first insulating layer (INS1),
**characterised in that**
the rear pad electrode (RPD) is formed to cover the rear line (RL) and contact the first insulating layer (INS1).

10. The method according to claim 9, further comprising forming a second insulating layer (INS2) on the rear pad electrode.

11. The method according to claim 9 or 10, wherein forming the pixel circuit layer comprises forming a first transistor on the first surface.

12. The method according to any one of claims 9 to 11, wherein forming the display element layer comprises disposing a light emitting element on the pixel circuit layer.

## Patentansprüche

1. Anzeigevorrichtung, umfassend:
eine Basisschicht (BSL), die eine erste Oberfläche (SF1) und eine zweite Oberfläche (SF2) beinhaltet, die der ersten Oberfläche (SF1) gegenüberliegt;
eine Pixelschaltungsschicht (PCL), die auf der ersten Oberfläche (SF1) angeordnet ist;
eine Anzeigeelementschicht (DPL), die auf der Pixelschaltungsschicht (PCL) angeordnet ist;
eine erste Isolierschicht (INS1), die auf der zweiten Oberfläche (SF2) angeordnet ist;
eine Planarisierungsschicht (PLL), die zwischen der zweiten Oberfläche (SF2) und der ersten Isolierschicht (INS1) angeordnet ist; und
eine hintere Leitung (RL), die auf der ersten Isolierschicht (INS1) angeordnet ist;
wobei die Planarisierungsschicht (PLL) organisches Material beinhaltet, **dadurch gekennzeichnet, dass**
eine hintere Anschlussflächenelektrode (RPD) an der hinteren Leitung (RL) angeordnet ist, um die hintere Leitung (RL) zu bedecken und die erste Isolierschicht (INS1) zu berühren.

2. Anzeigevorrichtung nach Anspruch 1, ferner umfassend:
eine zweite Isolierschicht (INS2), die die hintere Anschlussflächenelektrode (RPD) bedeckt, derart, dass mindestens ein Abschnitt einer oberen Oberfläche der hinteren Anschlussflächenelektrode freiliegt.

3. Anzeigevorrichtung nach Anspruch 1 oder 2, wobei die erste Isolierschicht transparentes anorganisches Isoliermaterial beinhaltet.

4. Anzeigevorrichtung nach Anspruch 1, 2 oder 3, wobei die Basisschicht ein starres Substrat umfasst.

5. Anzeigevorrichtung nach einem der vorhergehenden Ansprüche, wobei sich die hintere Leitung auf der zweiten Oberfläche in einer ersten Richtung erstreckt.

6. Anzeigevorrichtung nach einem der vorhergehenden Ansprüche, wobei die hintere Anschlussflächenelektrode transparentes leitfähiges Oxid beinhaltet.

7. Anzeigevorrichtung nach einem der vorhergehenden Ansprüche, wobei die Pixelschaltungsschicht einen ersten Transistor beinhaltet, der auf der ersten Oberfläche angeordnet ist.

8. Anzeigevorrichtung nach einem der vorhergehenden Ansprüche,
wobei die Anzeigeelementschicht ein lichtemittierendes Element umfasst und wobei das lichtemittierende Element Folgendes umfasst:
eine erste Halbleiterschicht;
eine zweite Halbleiterschicht, die sich von der ersten Halbleiterschicht unterscheidet; und
eine aktive Schicht, die zwischen der ersten Halbleiterschicht und der zweiten Halbleiterschicht angeordnet ist.

9. Verfahren zur Herstellung einer Anzeigevorrichtung, umfassend:
Vorbereiten einer Basisschicht (BSL), die eine erste Oberfläche (SF1) und eine zweite Oberfläche (SF2) beinhaltet, die der ersten Oberfläche (SF1) gegenüberliegt;
Bilden einer Pixelschaltungsschicht (PCL) und einer Anzeigeelementschicht (DPL) auf der ersten Oberfläche (SF1);
Bilden einer Planarisierungsschicht (PLL), die organisches Material umfasst, auf der zweiten Oberfläche (SF2);
Bilden einer ersten Isolierschicht (INS1) auf der Planarisierungsschicht (PLL); und
Bilden einer hinteren Leitung (RL) und einer hinteren Anschlussflächenelektrode (RPD) auf der ersten Isolierschicht (INS1),
**dadurch gekennzeichnet, dass**
die hintere Anschlussflächenelektrode (RPD) gebildet ist, um die hintere Leitung (RL) zu bedecken und die erste Isolierschicht (INS1) zu berühren.

10. Verfahren nach Anspruch 9, ferner umfassend das Bilden einer zweiten Isolierschicht (INS2) auf der hinteren Anschlussflächenelektrode.

11. Verfahren nach Anspruch 9 oder 10, wobei das Bilden der Pixelschaltungsschicht das Bilden eines ersten Transistors auf der ersten Oberfläche umfasst.

12. Verfahren nach einem der Ansprüche 9 bis 11, wobei das Bilden der Anzeigeelementschicht das Anordnen eines lichtemittierenden Elements auf der Pixelschaltungsschicht umfasst.

## Revendications

1. Dispositif d'affichage comprenant :
une couche de base (BSL) comprenant une première surface (SF1) et une seconde surface (SF2) qui est opposée à la première surface (SF1) ;
une couche de circuit de pixels (PCL) disposée sur la première surface (SF1) ;
une couche d'élément d'affichage (DPL) disposée sur la couche de circuit de pixels (PCL) ;
une première couche isolante (INS1) disposée sur la seconde surface (SF2) ;
une couche de planarisation (PLL) disposée entre la seconde surface (SF2) et la première couche isolante (INS1) ; et
une ligne arrière (RL) disposée sur la première couche isolante (INS1) ;
dans lequel la couche de planarisation (PLL) comprend un matériau organique,
**caractérisé en ce qu'**une électrode à plot arrière (RPD) est disposée sur la ligne arrière (RL) pour couvrir la ligne arrière (RL) et entrer en contact avec la première couche isolante (INS1).

2. Dispositif d'affichage selon la revendication 1, comprenant en outre :
une seconde couche isolante (INS2) recouvrant l'électrode à plot arrière (RPD) de sorte qu'au moins une partie d'une surface supérieure de l'électrode à plot arrière soit exposée.

3. Dispositif d'affichage selon la revendication 1 ou 2, dans lequel la première couche isolante comprend un matériau isolant inorganique transparent.

4. Dispositif d'affichage selon la revendication 1, 2 ou 3, dans lequel la couche de base comprend un substrat rigide.

5. Dispositif d'affichage selon l'une quelconque des revendications précédentes, dans lequel la ligne arrière s'étend sur la seconde surface dans une première direction.

6. Dispositif d'affichage selon l'une quelconque des revendications précédentes, dans lequel l'électrode à plot arrière comprend un oxyde conducteur transparent.

7. Dispositif d'affichage selon l'une quelconque des revendications précédentes, dans lequel la couche de circuit de pixels comprend un premier transistor disposé sur la première surface.

8. Dispositif d'affichage selon l'une quelconque des revendications précédentes,
dans lequel la couche d'élément d'affichage comprend un élément électroluminescent, et
dans lequel l'élément électroluminescent comprend :
une première couche semi-conductrice ;
une seconde couche semi-conductrice différente de la première couche semi-conductrice ;
et
une couche active disposée entre la première couche semi-conductrice et la seconde couche semi-conductrice.

9. Procédé de fabrication d'un dispositif d'affichage, comprenant :
la préparation d'une couche de base (BSL) comprenant une première surface (SF1) et une seconde surface (SF2) qui est opposée à la première surface (SF1) ;
la formation d'une couche de circuit de pixels (PCL) et d'une couche d'élément d'affichage (DPL) sur la première surface (SF1) ;
la formation d'une couche de planarisation (PLL) comprenant un matériau organique sur la seconde surface (SF2) ;
la formation d'une première couche isolante (INS1) sur la couche de planarisation (PLL) ;
et
la formation d'une ligne arrière (RL) et d'une électrode à plot arrière (RPD) sur la première couche isolante (INS1),
**caractérisé en ce que**
l'électrode à plot arrière (RPD) est formée pour couvrir la ligne arrière (RL) et entrer en contact avec la première couche isolante (INS1).

10. Procédé selon la revendication 9, comprenant en outre la formation d'une seconde couche isolante (INS2) sur l'électrode à plot arrière.

11. Procédé selon la revendication 9 ou 10, dans lequel la formation de la couche de circuit de pixels comprend la formation d'un premier transistor sur la première surface.

12. Procédé selon l'une quelconque des revendications 9 à 11, dans lequel la formation de la couche d'élément d'affichage comprend la disposition d'un élément électroluminescent sur la couche de circuit de pixels.
